# EUROPEAN PATENT SPECIFICATION

(11) **EP 4 571 819 B1**
(45) Date of publication and mention of the grant of the patent: **25.11.2026**
(21) Application number: 23865380.2
(22) Date of filing: 06.09.2023
(51) Int. Cl.: H10P 70/00, C11D 1/62, C11D 3/43, C09J 183/04, H10P 50/68

(54) **METHOD FOR CLEANING SEMICONDUCTOR SUBSTRATE, METHOD FOR PRODUCING PROCESSED SEMICONDUCTOR SUBSTRATE, AND PEELING AND DISSOLVING COMPOSITION**
VERFAHREN ZUR REINIGUNG EINES HALBLEITERSUBSTRATS, VERFAHREN ZUR HERSTELLUNG EINES VERARBEITETEN HALBLEITERSUBSTRATS UND SCHÄL- UND AUFLÖSUNGSZUSAMMENSETZUNG
PROCÉDÉ DE NETTOYAGE D'UN SUBSTRAT SEMI-CONDUCTEUR, PROCÉDÉ DE PRODUCTION D'UN SUBSTRAT SEMI-CONDUCTEUR TRAITÉ, ET COMPOSITION DE PELAGE ET DE DISSOLUTION

(30) Priority: 13.09.2022 JP 2022144987
(43) Date of publication of application: 18.06.2025
(73) Proprietor: Nissan Chemical Corporation, Tokyo 103-6119 (JP)
(72) Inventor: YAGYU, Masafumi, Toyama-shi, Toyama 939-2792 (JP); SHINJO, Tetsuya, Toyama-shi, Toyama 939-2792 (JP)
(74) Representative: Hoffmann Eitle
(86) International application number: PCT/JP2023/032514
(87) International publication number: WO 2024/058025

(56) References cited:
- WO-A1-2021/100651
- WO-A1-2021/106460
- WO-A1-2022/045026
- WO-A1-2023/042811
- JP-A- 2021 153 182
- JP-A- 2021 153 182
- US-A1- 2021 317 390

## Description

### Technical Field

The present invention relates to a method for cleaning a semiconductor substrate, a method for producing a processed semiconductor substrate, and a releasing and dissolving composition.

### Background Art

For a semiconductor wafer that has been conventionally integrated in a two-dimensional planar direction, a semiconductor integration technique is required in which a planar surface is further integrated (laminated) also in a three-dimensional direction for the purpose of further integration. This three-dimensional lamination is a technique of integrating layers while connecting them by a through silicon via (TSV). At the time of multi-layer integration, respective wafers to be integrated are thinned by polishing on the side opposite to the formed circuit surface (that is, the back surface), and the thinned semiconductor wafers are laminated.

A pre-thinned semiconductor wafer (also referred to simply as a wafer here) is adhered to a support for polishing with a polishing apparatus. The adhesion at that time need to be easily released after polishing, and therefore is referred to as temporary adhesion. This temporary adhesion needs to be easily removed from the support, and when a large force is applied for the removal, the thinned semiconductor wafer may be cut or deformed, and it is easily removed so that such a thing does not occur. However, at the time of polishing the back surface of a semiconductor wafer, it is not preferable that the semiconductor wafer is detached or displaced due to polishing stress. Therefore, the performance required for temporary adhesion is to withstand the stress during polishing and to be easily removed after polishing. For example, there is a demand for performance having a high stress (strong adhesive force) in the planar direction at the time of polishing and a low stress (weak adhesive force) in a direction intersecting the planar direction, that is, in the longitudinal direction at the time of removal. In addition, the temperature may become a high temperature of 150°C or higher in the processing step, and further, heat resistance is also required.

Under such circumstances, in the semiconductor field, a polysiloxane-based adhesive that can have such performance is mainly used as a temporary adhesive. In polysiloxane-based adhesion using a polysiloxane-based adhesive, an adhesive residue often remains on a substrate surface after a thinned substrate is released, but in order to avoid defects in subsequent steps, a cleaning agent composition for removing the residue and cleaning a semiconductor substrate surface has been developed (see, for example, Patent Literatures 1 and 2). Patent Literature 1 discloses a siloxane resin remover containing a polar aprotic solvent and a quaternary ammonium hydroxide, and Patent Literature 2 discloses a cured resin remover containing an alkyl ammonium fluoride. However, in the recent semiconductor field, there is always a demand for a new cleaning agent composition, and there is always a demand for an effective cleaning agent composition and an effective cleaning method.

Furthermore, EP 4 404 244 A1 is prior art under Art. 54(3) EPC and inter alia concerns a method for cleaning a semiconductor substrate, the method comprising a step of peeling and dissolving an adhesive layer formed on a semiconductor substrate. A peeling and dissolving composition contains a quaternary ammonium salt; an amide-based solvent; and a solvent represented by the formula L¹-L³-L², and L¹ and L² each independently represent an alkyl group having 2 to 5 carbon atoms, and L³ represents O or S.

In US 2021/317390 A1, a composition is described which comprises a quaternary alkylammonium fluoride or a hydrate thereof and an aprotic solvent. The aprotic solvent includes (A) an N-substituted amide compound having 4 or more carbon atoms and not containing active hydrogen on a nitrogen atom, and (B) an ether compound.

### Citation List

### Patent Literature

Patent Literature 1: WO 2014/092022 A
Patent Literature 2: US 6,818,608

### Summary of Invention

### Technical Problem

The cleaning agent compositions described in Patent Literatures 1 and 2 attempt to remove the adhesive residue from the substrate surface by dissolving the adhesive residue on the substrate surface, but it has been found that it takes a long time to remove the adhesive residue from the substrate surface by dissolution in this manner.

Meanwhile, as a result of examining a cleaning agent composition, the present inventors have found that when a composition containing a specific component is used, the adhesive layer can be released from the substrate by swelling the adhesive layer. When the composition containing a specific component is used, the adhesive layer can be removed from the substrate in a short time.

However, there is room for improvement from the viewpoint of removing the adhesive residue from the substrate surface more cleanly in a shorter time by a simple operation, and in search of a more effective cleaning method, the development of a new cleaning method and a composition used in the cleaning method is underway.

The present invention has been made in view of the above circumstances, and an object of the present invention is to provide a method for cleaning a semiconductor substrate, capable of removing (cleaning) an adhesive layer obtained using, for example, a siloxane-based adhesive from a semiconductor substrate having the adhesive layer on a surface thereof more cleanly in a shorter time by a simple operation, a method for producing a processed semiconductor substrate including such a cleaning method, and a composition used in such a cleaning method.

### Solution to Problem

As a result of intensive studies to solve the above problem, the present inventors have found that the above problem can be solved by cleaning an adhesive layer on a semiconductor substrate, in particular, an adhesive layer which is a cured film obtained from a siloxane-based adhesive containing a polyorganosiloxane component (A') that is cured by a hydrosilylation reaction using a composition containing a specific component, thereby simultaneously swelling, releasing, and dissolving the adhesive layer by one cleaning operation, and removing the adhesive layer from the semiconductor substrate, and completed the present invention.

That is, the present invention provides a method for cleaning a semiconductor substrate, the method including a step of releasing and dissolving an adhesive layer formed on a semiconductor substrate using a releasing and dissolving composition,
wherein the releasing and dissolving composition corresponds to at least one of (i) to (iii) below:
(i) the releasing and dissolving composition contains
   a component [I] below, a component [II] below, and a component [III] below, and
   wherein a content of component [I] is 0.1 to 5 mass%, with respect to the releasing and dissolving composition, and
   with respect to 100 mass% of aprotic solvents in the releasing and dissolving composition, a content of the component [II] is 5 mass% or more and 20 mass% or less, and a content of the component [III] is 60 mass% or more;
(ii) the releasing and dissolving composition contains a component [I] below, a component [II] below, a component [III] below, and a component [IV] below,
   the component [IV] contains a solvent represented by formula (L) below, and
   wherein a content of the component [I] is 0.1 to 5 mass%, with respect to the releasing and dissolving composition, and
   with respect to 100 mass% of aprotic solvents in the releasing and dissolving composition, a content of the component [III] is more than 31 mass%, a content of the component [IV] is less than 30 mass%, and a content of the component [II] is 5 mass% or more and 50 mass% or less; and
(iii) the releasing and dissolving composition contains
   a component [I] below, a component [II] below, a component [III] below, and a component [IV] below,
   the component [IV] contains a solvent represented by formula (T) below, and
   wherein a content of the component [I] is 0.1 to 5 mass%, with respect to the releasing and dissolving composition, and
   with respect to 100 mass% of aprotic solvents in the releasing and dissolving composition, a content of the component [III] is more than 31 mass%, a content of the component [IV] is less than 30 mass%, and a content of the component [II] is 5 mass% or and 20 mass% or less,
   in which the component [I] represents a quaternary ammonium salt,
   the component [II] represents an amide-based solvent, which is an acid amide derivative represented by formula (Z) below or a compound represented by formula (Y) below,
   the component [III] represents a solvent represented by formula (G) below,
   the component [IV] represents a solvent represented by formula (T) below or formula (L) below, and
   aprotic solvents are solvents having no hydroxyl group (-OH): 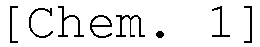 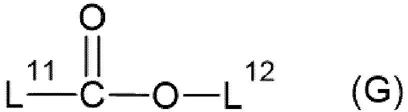
   wherein L¹¹ and L¹² each independently represent an alkyl group having 1 to 6 carbon atoms, and a total number of carbon atoms in the alkyl group of L¹¹ and the alkyl group of L¹² is 7 or less, 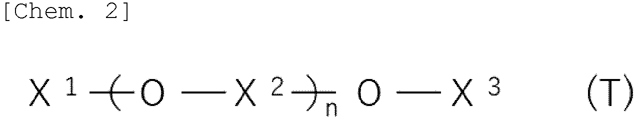
   X¹ and X³ each independently represent an alkyl group or an acyl group (X⁴-C(=O)-), X² represents an alkylene group, n represents 2 or 3, and X⁴ represents an alkyl group,

      [Chem. 3] L¹-L³-L² (L)
   wherein L¹ and L² each independently represent an alkyl group having 2 to 5 carbon atoms, and L³ represents O or S, 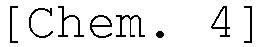 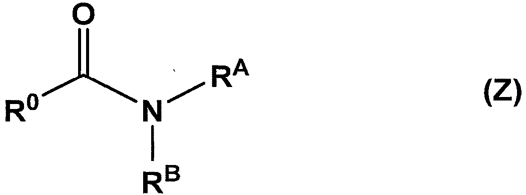
   wherein R⁰ represents an ethyl group, a propyl group, or an isopropyl group, and R^{A} and R^{B} each independently represent an alkyl group having 1 to 4 carbon atoms, 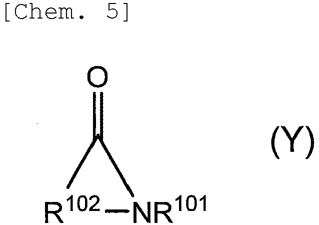
   wherein R¹⁰¹ represents a hydrogen atom or an alkyl group having 1 to 6 carbon atoms, and R¹⁰² represents an alkylene group having 1 to 6 carbon atoms or a group represented by formula (Y1) below: 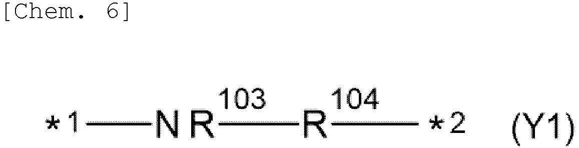
   wherein R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in formula (Y), and *2 represents a bond bonded to a nitrogen atom in formula (Y).

The present invention further provides a method for producing a processed semiconductor substrate, the method including:
a first step of producing a laminate including a semiconductor substrate, a support substrate, and an adhesive layer formed from an adhesive composition;
a second step of processing the semiconductor substrate of the produced laminate;
a third step of separating the semiconductor substrate and the adhesive layer from the support substrate; and
a fourth step of releasing and dissolving the adhesive layer using the releasing and dissolving composition according to the method of the present invention.
The present invention further provides a releasing and dissolving composition for releasing and dissolving an adhesive layer formed on a semiconductor substrate when the semiconductor substrate is cleaned to remove the adhesive layer,
wherein the releasing and dissolving composition corresponds to at least one of (i) to (iii) below:
   (i) the releasing and dissolving composition contains
      a component [I] below, a component [II] below, and a component [III] below, and
      wherein a content of component [I] is 0.1 to 5 mass%, with respect to the releasing and dissolving composition, and
      with respect to 100 mass% of aprotic solvents in the releasing and dissolving composition, a content of the component [II] is 5 mass% or more and 20 mass% or less, and a content of the component [III] is 60 mass% or more;
   (ii) the releasing and dissolving composition contains
      a component [I] below, a component [II] below, a component [III] below, and a component [IV] below,
      the component [IV] contains a solvent represented by formula (L) below, and
      wherein a content of the component [I] is 0.1 to 5 mass%, with respect to the releasing and dissolving composition, and
      with respect to 100 mass% of aprotic solvents in the releasing and dissolving composition, a content of the component [III] is more than 31 mass%, a content of the component [IV] is less than 30 mass%, and a content of the component [II] is 5 mass% or more and 50 mass% or less; and
   (iii) the releasing and dissolving composition contains
      a component [I] below, a component [II] below, a component [III] below, and a component [IV] below,
      the component [IV] contains a solvent represented by formula (T) below, and
      wherein a content of the component [I] is 0.1 to 5 mass%, with respect to the releasing and dissolving composition, and
      with respect to 100 mass% of aprotic solvents in the releasing and dissolving composition, a content of the component [III] is more than 31 mass%, a content of the component [IV] is less than 30 mass%, and a content of the component [II] is 5 mass% or and 20 mass% or less,
      in which the component [I] represents a quaternary ammonium salt,
      the component [II] represents an amide-based solvent, which is an acid amide derivative represented by formula (Z) below or a compound represented by formula (Y) below,
      the component [III] represents a solvent represented by formula (G) below,
      the component [IV] represents a solvent represented by formula (T) below or formula (L) below,
      aprotic solvents are solvents having no hydroxyl group (-OH): 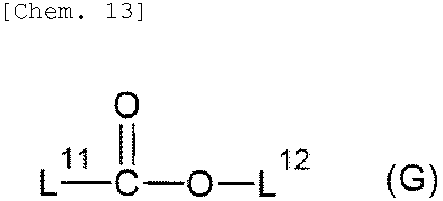
      wherein L¹¹ and L¹² each independently represent an alkyl group having 1 to 6 carbon atoms, and a total number of carbon atoms in the alkyl group of L¹¹ and the alkyl group of L¹² is 7 or less, 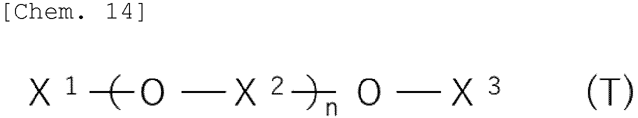
      X¹ and X³ each independently represent an alkyl group or an acyl group (X⁴-C(=O) -), X² represents an alkylene group, n represents 2 or 3, and X⁴ represents an alkyl group,

         [Chem. 15] **L¹-L³-L² (L)**
      wherein L¹ and L² each independently represent an alkyl group having 2 to 5 carbon atoms, and L³ represents O or S, 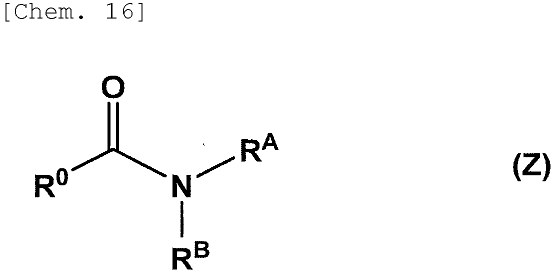
      wherein R⁰ represents an ethyl group, a propyl group, or an isopropyl group, and R^{A} and R^{B} each independently represent an alkyl group having 1 to 4 carbon atoms, 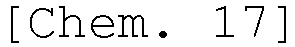 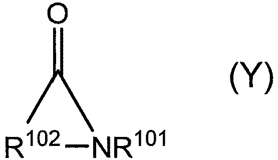
      wherein R¹⁰¹ represents a hydrogen atom or an alkyl group having 1 to 6 carbon atoms, and R¹⁰² represents an alkylene group having 1 to 6 carbon atoms or a group represented by formula (Y1) below: 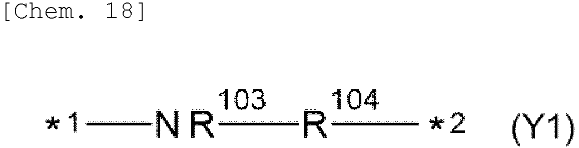
      wherein R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in formula (Y), and *2 represents a bond bonded to a nitrogen atom in formula (Y).

### Advantageous Effects of Invention

According to the present invention, it is possible to provide a method for cleaning a semiconductor substrate, capable of removing (cleaning) an adhesive layer from a semiconductor substrate having the adhesive layer on a surface thereof more cleanly in a shorter time by a simple operation, a method for producing a processed semiconductor substrate including such a cleaning method, and a composition used in such a cleaning method.

### Description of Embodiments

Hereinafter, the present invention will be described in detail.

### (Method for cleaning semiconductor substrate)

The method for cleaning a semiconductor substrate of the present invention includes a step of releasing and dissolving an adhesive layer on a semiconductor substrate using a releasing and dissolving composition.

The releasing and dissolving composition corresponds to at least one of (i) to (iii) below:
(i) the releasing and dissolving composition contains
   a component [I] below, a component [II] below, and a component [III] below, and
   wherein a content of component [I] is 0.1 to 5 mass%, with respect to the releasing and dissolving composition, and
   with respect to 100 mass% of aprotic solvents in the releasing and dissolving composition, a content of the component [II] is 5 mass% or more and 20 mass% or less, and a content of the component [III] is 60 mass% or more;
   (ii) the releasing and dissolving composition contains
      a component [I] below, a component [II] below, a component [III] below, and a component [IV] below,
      the component [IV] contains a solvent represented by formula (L) below, and
      wherein a content of the component [I] is 0.1 to 5 mass%, with respect to the releasing and dissolving composition, and
      with respect to 100 mass% of aprotic solvents in the releasing and dissolving composition, a content of the component [III] is more than 31 mass%, a content of the component [IV] is less than 30 mass%, and a content of the component [II] is 5 mass% or more and 50 mass% or less; and
   (iii) the releasing and dissolving composition contains
      a component [I] below, a component [II] below, a component [III] below, and a component [IV] below,
      the component [IV] contains a solvent represented by formula (T) below, and
      wherein a content of the component [I] is 0.1 to 5 mass%, with respect to the releasing and dissolving composition, and
      with respect to 100 mass% of aprotic solvents in the releasing and dissolving composition, a content of the component [III] is more than 31 mass%, a content of the component [IV] is less than 30 mass%, and a content of the component [II] is 5 mass% or and 20 mass% or less,
      in which the component [I] represents a quaternary ammonium salt,
      the component [II] represents an amide-based solvent, which is an acid amide derivative represented by formula (Z) below or a compound represented by formula (Y) below,
      the component [III] represents a solvent represented by formula (G) below,
      the component [IV] represents a solvent represented by formula (T) below or formula (L) below, and
      aprotic solvents are solvents having no hydroxyl group (-OH) : 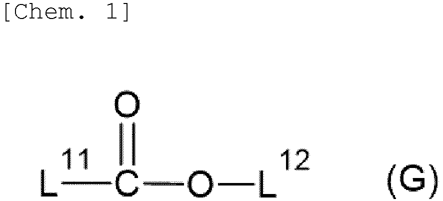
      wherein L¹¹ and L¹² each independently represent an alkyl group having 1 to 6 carbon atoms, and a total number of carbon atoms in the alkyl group of L¹¹ and the alkyl group of L¹² is 7 or less, 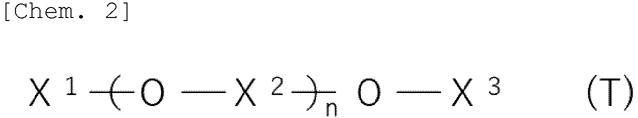
      X¹ and X³ each independently represent an alkyl group or an acyl group (X⁴-C(=O) -), X² represents an alkylene group, n represents 2 or 3, and X⁴ represents an alkyl group,

         [Chem. 3] **L¹-L³-L² (L)**
      wherein L¹ and L² each independently represent an alkyl group having 2 to 5 carbon atoms, and L³ represents O or S, 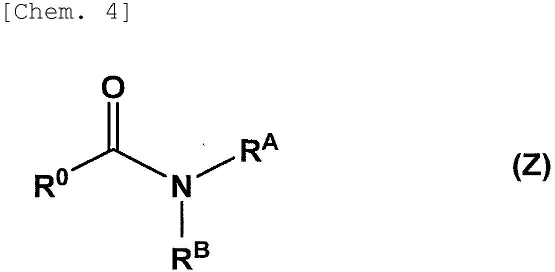
      wherein R⁰ represents an ethyl group, a propyl group, or an isopropyl group, and R^{A} and R^{B} each independently represent an alkyl group having 1 to 4 carbon atoms, 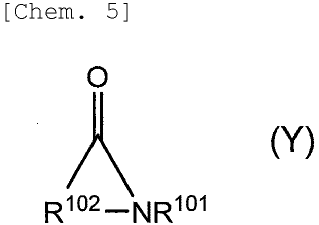
      wherein R¹⁰¹ represents a hydrogen atom or an alkyl group having 1 to 6 carbon atoms, and R¹⁰² represents an alkylene group having 1 to 6 carbon atoms or a group represented by formula (Y1) below: 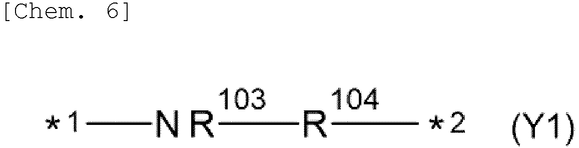
      wherein R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in formula (Y), and *2 represents a bond bonded to a nitrogen atom in formula (Y).

### <Semiconductor substrate>

The main material forming the entire semiconductor substrate is not particularly limited as long as it is used for this type of application, and examples thereof include silicon, silicon carbide, and a compound semiconductor.

The shape of the semiconductor substrate is not particularly limited, and is, for example, a disk shape. Note that the disk-shaped semiconductor substrate does not need to have a completely circular surface. For example, the outer periphery of the semiconductor substrate may have a straight portion called an orientation flat or may have a cut called a notch.

The thickness of the disk-shaped semiconductor substrate may be appropriately determined according to the purpose of use of the semiconductor substrate and the like, and is not particularly limited, and is, for example, 500 to 1,000 µm.

The diameter of the disk-shaped semiconductor substrate may be appropriately determined according to the purpose of use of the semiconductor substrate and the like, and is not particularly limited, and is, for example, 100 to 1,000 mm.

The semiconductor substrate is, for example, a wafer, and specific examples thereof include, but are not limited to, a silicon wafer having a diameter of about 300 mm and a thickness of about 770 µm.

### <Adhesive layer>

The adhesive layer on the semiconductor substrate is, for example, a film obtained from an adhesive composition containing an adhesive component (S).

The adhesive component (S) is not particularly limited as long as it is used for this type of application, and examples thereof include a siloxane-based adhesive, an acrylic resin-based adhesive, an epoxy resin-based adhesive, a polyamide-based adhesive, a polystyrene-based adhesive, a polyimide adhesive, and a phenol resin-based adhesive.

Among them, the adhesive component (S) is preferably a siloxane-based adhesive, which exhibits a suitable adhesive ability during processing of a wafer or the like, can be suitably released after processing, and is excellent in heat resistance.

### <<Adhesive composition>>

In a preferred aspect, the adhesive composition used in the present invention contains a component (A) that is cured by a hydrosilylation reaction as the adhesive component (S).

In addition, the adhesive composition used in the present invention contains a polyorganosiloxane in a preferred aspect.

The component (A) may be a component that is cured by a hydrosilylation reaction, or may be a polyorganosiloxane component (A') that is cured by a hydrosilylation reaction.

In another preferred aspect, the component (A) contains, for example, as an example of the component (A'), a polyorganosiloxane (a1) having an alkenyl group having 2 to 40 carbon atoms bonded to a silicon atom, a polyorganosiloxane (a2) having a Si-H group, and a platinum group metal-based catalyst (A2). Here, the alkenyl group having 2 to 40 carbon atoms may be substituted. Examples of the substituent include a halogen atom, a nitro group, a cyano group, an amino group, a hydroxy group, a carboxyl group, an aryl group, and a heteroaryl group.

In another preferred aspect, the polyorganosiloxane component (A') that is cured by a hydrosilylation reaction includes a polysiloxane (A1) containing one or two or more units selected from the group consisting of a siloxane unit (Q unit) represented by SiO₂, a siloxane unit (M unit) represented by R¹R²R³SiO_{1/2}, a siloxane unit (D unit) represented by R⁴R⁵SiO_{2/2}, and a siloxane unit (T unit) represented by R⁶SiO_{3/2}, and a platinum group metal-based catalyst (A2). The polysiloxane (A1) includes: a polyorganosiloxane (a1') containing one or two or more units selected from the group consisting of a siloxane unit (Q' unit) represented by SiO₂, a siloxane unit (M' unit) represented by R¹'R²'R³'SiO_{1/2}, a siloxane unit (D' unit) represented by R⁴'R⁵'SiO_{2/2}, and a siloxane unit (T' unit) represented by R⁶'SiO_{3/2}, and also containing at least one selected from the group consisting of M' unit, D' unit, and T' unit, and a polyorganosiloxane (a2') containing one or two or more units selected from the group consisting of a siloxane unit (Q" unit) represented by SiO₂, a siloxane unit (M" unit) represented by R¹"R²"R³"SiO_{1/2}, a siloxane unit (D" unit) represented by R⁴"R⁵"SiO_{2/2}, and a siloxane unit (T" unit) represented by R⁶"SiO_{3/2}, and also containing at least one selected from the group consisting of M" unit, D" unit, and T" unit.

Note that (a1') is an example of (a1), and (a2') is an example of (a2).

R¹ to R⁶ are groups or atoms bonded to a silicon atom, and each independently represent an optionally substituted alkyl group, an optionally substituted alkenyl group, or a hydrogen atom. Examples of the substituent include a halogen atom, a nitro group, a cyano group, an amino group, a hydroxy group, a carboxyl group, an aryl group, and a heteroaryl group.

R¹' to R⁶' are groups bonded to a silicon atom and each independently represent an optionally substituted alkyl group or an optionally substituted alkenyl group, but at least one of R¹' to R⁶' is an optionally substituted alkenyl group. Examples of the substituent include a halogen atom, a nitro group, a cyano group, an amino group, a hydroxy group, a carboxyl group, an aryl group, and a heteroaryl group.

R¹" to R⁶" are groups or atoms bonded to a silicon atom and each independently represent an optionally substituted alkyl group or a hydrogen atom, but at least one of R¹" to R⁶" is a hydrogen atom. Examples of the substituent include a halogen atom, a nitro group, a cyano group, an amino group, a hydroxy group, a carboxyl group, an aryl group, and a heteroaryl group.

The alkyl group may be linear, branched, or cyclic, and is preferably a linear or branched alkyl group. The number of carbon atoms thereof is not particularly limited, and is usually 1 to 40, preferably 30 or less, more preferably 20 or less, and still more preferably 10 or less.

Specific examples of the optionally substituted linear or branched alkyl group include, but are not limited to, a methyl group, an ethyl group, a n-propyl group, an i-propyl group, a n-butyl group, an i-butyl group, a s-butyl group, a tertiary butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, and a 1-ethyl-2-methyl-n-propyl group. The number of carbon atoms thereof is usually 1 to 14, preferably 1 to 10, and more preferably 1 to 6. Among them, a methyl group is particularly preferable.

Specific examples of the optionally substituted cyclic alkyl group include, but are not limited to, cycloalkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group, and bicycloalkyl groups such as a bicyclobutyl group, a bicyclopentyl group, a bicyclohexyl group, a bicycloheptyl group, a bicyclooctyl group, a bicyclononyl group, and a bicyclodecyl group. The number of carbon atoms thereof is usually 3 to 14, preferably 4 to 10, and more preferably 5 or 6.

The alkenyl group may be a linear or branched alkenyl group, and the number of carbon atoms thereof is not particularly limited, and is usually 2 to 40, preferably 30 or less, more preferably 20 or less, and still more preferably 10 or less.

Specific examples of the optionally substituted linear or branched alkenyl group include, but are not limited to, a vinyl group, an allyl group, a butenyl group, and a pentenyl group. The number of carbon atoms thereof is usually 2 to 14, preferably 2 to 10, and more preferably 1 to 6. Among them, an ethenyl group and a 2-propenyl group are particularly preferable.

Specific examples of the optionally substituted cyclic alkenyl group include, but are not limited to, cyclopentenyl and cyclohexenyl. The number of carbon atoms thereof is usually 4 to 14, preferably 5 to 10, and more preferably 5 or 6.

As described above, the polysiloxane (A1) contains the polyorganosiloxane (a1') and the polyorganosiloxane (a2'), and an alkenyl group contained in the polyorganosiloxane (a1') and a hydrogen atom (Si-H group) contained in the polyorganosiloxane (a2') form a crosslinked structure through a hydrosilylation reaction by the platinum group metal-based catalyst (A2) to cause curing. As a result, a cured film is formed.

The polyorganosiloxane (a1') contains one or two or more units selected from the group consisting of Q' unit, M' unit, D' unit, and T' unit, and contains at least one selected from the group consisting of M' unit, D' unit, and T' unit. As the polyorganosiloxane (a1'), two or more types of polyorganosiloxanes satisfying such conditions may be used in combination.

Examples of preferred combinations of two or more selected from the group consisting of Q' unit, M' unit, D' unit, and T' unit include, but are not limited to, (Q' unit and M' unit), (D' unit and M' unit), (T' unit and M' unit), and (Q' unit, T' unit, and M' unit).

When two or more types of polyorganosiloxanes contained in the polyorganosiloxane (a1'), a combination of (Q' unit and M' unit) and (D' unit and M' unit), a combination of (T' unit and M' unit) and (D' unit and M' unit), and a combination of (Q' unit, T' unit, and M' unit) and (T' unit and M' unit) are preferable, but the combination is not limited thereto.

The polyorganosiloxane (a2') contains one or two or more units selected from the group consisting of Q" unit, M" unit, D" unit, and T" unit, and contains at least one selected from the group consisting of M" unit, D" unit, and T" unit. As the polyorganosiloxane (a2'), two or more types of polyorganosiloxanes satisfying such conditions may be used in combination.

Examples of preferred combinations of two or more selected from the group consisting of Q" unit, M" unit, D" unit, and T" unit include, but are not limited to, (M" unit and D" unit), (Q" unit and M" unit), and (Q" unit, T" unit, and M" unit).

The polyorganosiloxane (a1') is formed of siloxane units in which alkyl groups and/or alkenyl groups are bonded to silicon atoms thereof, and the proportion of alkenyl groups in all substituents represented by R¹' to R⁶' is preferably 0.1 to 50.0 mol%, more preferably 0.5 to 30.0 mol%, and the remaining R¹' to R⁶' can be alkyl groups.

The polyorganosiloxane (a2') is formed of a siloxane unit in which an alkyl group and/or a hydrogen atom is bonded to a silicon atom thereof, and the proportion of hydrogen atoms in all substituents and substitutional atoms represented by R¹" to R⁶" is preferably 0.1 to 50.0 mol%, more preferably 10.0 to 40.0 mol%, and the remaining R¹" to R⁶" can be alkyl groups.

When the component (A) contains (a1) and (a2), in a preferred aspect of the present invention, the molar ratio between the alkenyl groups contained in the polyorganosiloxane (a1) and the hydrogen atoms constituting the Si-H bonds contained in the polyorganosiloxane (a2) is in the range of 1.0 : 0.5 to 1.0 : 0.66.

The weight average molecular weight of the polysiloxane such as the polyorganosiloxane (a1) or the polyorganosiloxane (a2) is not particularly limited, and is usually 500 to 1,000,000, and is preferably 5,000 to 50,000 from the viewpoint of realizing the effects of the present invention with good reproducibility.

In the present invention, the weight average molecular weight, the number average molecular weight, and the dispersity of the polyorganosiloxanes can be measured, for example, using a GPC apparatus (EcoSEC, HLC-8320GPC, manufactured by Tosoh Corporation) and a GPC column (TSKgel SuperMultipore HZ-N and TSKgel SuperMultipore HZ-H, manufactured by Tosoh Corporation), at a column temperature of 40°C, using tetrahydrofuran as an eluent (elution solvent), at a flow amount (flow rate) of 0.35 mL/min, and using polystyrene (Shodex from Showa Denko K.K.) as a standard sample.

The viscosity of each of the polyorganosiloxane (a1) and the polyorganosiloxane (a2) is not particularly limited, and is usually 10 to 1,000,000 (mPa·s), and is preferably 50 to 20,000 (mPa·s) from the viewpoint of realizing the effects of the present invention with good reproducibility. The viscosity of the polyorganosiloxane (a1) and the polyorganosiloxane (a2) are values measured with an E-type rotational viscometer at 25°C.

The polyorganosiloxane (a1) and the polyorganosiloxane (a2) react with each other by a hydrosilylation reaction to form a film. Therefore, the mechanism of curing is different from that via, for example, a silanol group. Thus, any siloxane does not need to contain a silanol group or a functional group that forms a silanol group by hydrolysis, such as an alkyloxy group.

In a preferred aspect of the present invention, the adhesive composition contains a platinum group metal-based catalyst (A2) together with the polyorganosiloxane component (A').

Such a platinum-based metal catalyst is a catalyst for promoting the hydrosilylation reaction between the alkenyl group of the polyorganosiloxane (a1) and the Si-H group of the polyorganosiloxane (a2).

Specific examples of the platinum-based metal catalyst include, but are not limited to, platinum black, platinum(II) chloride, chloroplatinic acid, a reaction product of chloroplatinic acid and a monohydric alcohol, a complex of chloroplatinic acid and an olefin, and platinum bisacetoacetate.

Examples of the complex of platinum and an olefin include, but are not limited to, a complex of divinyltetramethyldisiloxane and platinum.

The amount of the platinum group metal-based catalyst (A2) is not particularly limited, and is usually in the range of 1.0 to 50.0 ppm with respect to the total amount of the polyorganosiloxane (a1) and the polyorganosiloxane (a2).

The polyorganosiloxane component (A') may contain a polymerization inhibitor (A3) for the purpose of preventing the progress of the hydrosilylation reaction.

The polymerization inhibitor is not particularly limited as long as the polymerization inhibitor can prevent the progress of the hydrosilylation reaction, and specific examples thereof include alkynyl alcohols such as 1-ethynyl-1-cyclohexanol and 1,1-diphenyl-2-propion-1-ol.

The amount of the polymerization inhibitor is not particularly limited, and is usually 1,000.0 ppm or more with respect to the total amount of the polyorganosiloxane (a1) and the polyorganosiloxane (a2) from the viewpoint of obtaining the effect, and is 10,000.0 ppm or less from the viewpoint of preventing excessive inhibition of the hydrosilylation reaction.

The adhesive composition used in the present invention may contain a release agent component (B). By including such a release agent component (B) in the adhesive composition used in the present invention, the obtained adhesive layer can be suitably released with good reproducibility.

Typical examples of the release agent component (B) include a polyorganosiloxane. In a preferred aspect, specific examples thereof include, but are not limited to, an epoxy group-containing polyorganosiloxane, a methyl group-containing polyorganosiloxane, and a phenyl group-containing polyorganosiloxane.

In another preferred aspect, examples of the release agent component (B) include polydimethylsiloxane, and the polydimethylsiloxane may be modified. Examples of the optionally modified polydimethylsiloxane include, but are not limited to, an epoxy group-containing polydimethylsiloxane, an unmodified polydimethylsiloxane, and a phenyl group-containing polydimethylsiloxane.

The weight average molecular weight of the polyorganosiloxane as the release agent component (B) is not particularly limited, and is usually 100,000 to 2,000,000, and is preferably 200,000 to 1,200,000, and more preferably 300,000 to 900,000 from the viewpoint of realizing the effects of the present invention with good reproducibility. In addition, the dispersity is not particularly limited, and is usually 1.0 to 10.0, and is preferably 1.5 to 5.0, and more preferably 2.0 to 3.0 from the viewpoint of realizing suitable release with good reproducibility, and the like. The weight average molecular weight and the dispersity can be measured by the above-described method related to the polysiloxane.

The complex viscosity of the polyorganosiloxane as the release agent component (B) can be measured at 25°C using a rheometer (for example, Rheometer MCR-302 manufactured by Anton Paar GmbH).

Examples of the epoxy group-containing polyorganosiloxane include those containing a siloxane unit (D^{1C} unit) represented by R¹¹R¹²SiO_{2/2}.

R¹¹ is a group bonded to a silicon atom and represents an alkyl group, R¹² is a group bonded to a silicon atom and represents an epoxy group or an organic group containing an epoxy group, and specific examples of the alkyl group include the above-described examples.

The epoxy group in the epoxy group-containing organic group may be an independent epoxy group without being fused to another ring, or may be an epoxy group forming a fused ring with another ring, such as a 1,2-epoxycyclohexyl group.

Specific examples of the epoxy group-containing organic group include, but are not limited to, 3-glycidoxypropyl and 2-(3,4-epoxycyclohexyl)ethyl.

In the present invention, preferred examples of the epoxy group-containing polyorganosiloxane include, but are not limited to, an epoxy group-containing polydimethylsiloxane.

The epoxy group-containing polyorganosiloxane contains the above-described siloxane unit (D¹⁰ unit), but may contain Q unit, M unit, and/or T unit in addition to D¹⁰ unit.

In a preferred aspect of the present invention, specific examples of the epoxy group-containing polyorganosiloxane include a polyorganosiloxane formed only of D^{1C} unit, a polyorganosiloxane containing D¹⁰ unit and Q unit, a polyorganosiloxane containing D¹⁰ unit and M unit, a polyorganosiloxane containing D¹⁰ unit and T unit, a polyorganosiloxane containing D¹⁰ unit, Q unit, and M unit, a polyorganosiloxane containing D¹⁰ unit, M unit, and T unit, and a polyorganosiloxane containing D¹⁰ unit, Q unit, M unit, and T unit.

The epoxy group-containing polyorganosiloxane is preferably an epoxy group-containing polydimethylsiloxane having an epoxy value of 0.1 to 5. In addition, the weight average molecular weight thereof is not particularly limited, and is usually from 1,500 to 500,000, and is preferably 100,000 or less from the viewpoint of preventing precipitation in the adhesive.

Specific examples of the epoxy group-containing polyorganosiloxane include, but are not limited to, those represented by formulae (E1) to (E3). 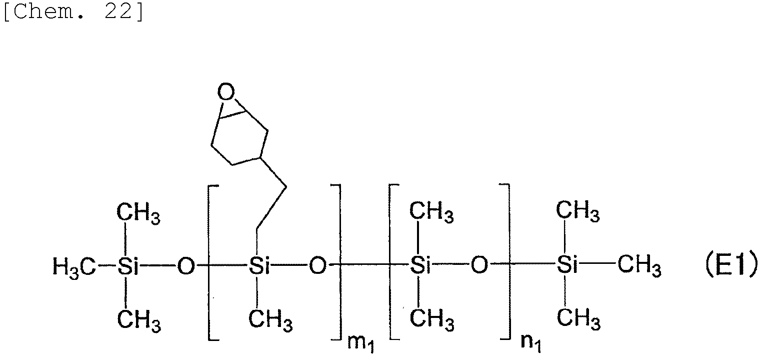 m₁ and n₁ each represent the number of repeating units, and are positive integers. 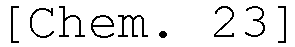 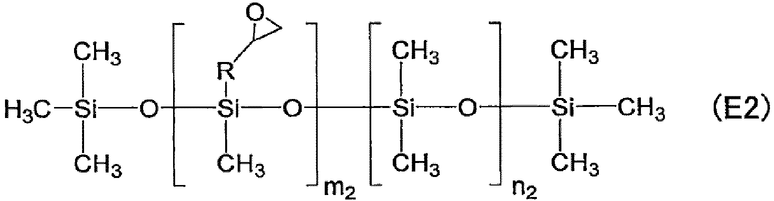 m₂ and n₂ each represent the number of repeating units and are positive integers, and R is an alkylene group having 1 to 10 carbon atoms. 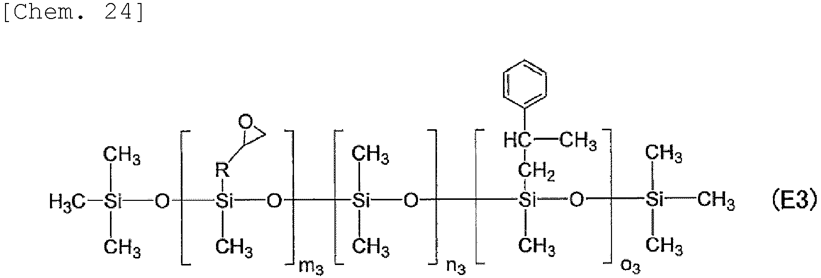 m₃, n₃, and o₃ each represent the number of repeating units and are positive integers, and R is an alkylene group having 1 to 10 carbon atoms.

Examples of the methyl group-containing polyorganosiloxane include those containing a siloxane unit (D²⁰⁰ unit) represented by R²¹⁰R²²⁰SiO_{2/2}, and preferably those containing a siloxane unit (D²⁰ unit) represented by R²¹R²¹SiO_{2/2}.

R²¹⁰ and R²²⁰ are groups bonded to silicon atoms, and each independently represent an alkyl group, but at least one thereof is a methyl group, and specific examples of the alkyl group include the above-described examples.

R²¹ is a group bonded to a silicon atom and represents an alkyl group, and specific examples of the alkyl group include the above-described examples. Among them, a methyl group is preferable as R²¹.

In the present invention, preferred examples of the methyl group-containing polyorganosiloxane include, but are not limited to, polydimethylsiloxane.

The methyl group-containing polyorganosiloxane contains the above-described siloxane unit (D²⁰⁰ unit or D²⁰ unit), but may contain Q unit, M unit, and/or T unit in addition to D²⁰⁰ unit and D²⁰ unit.

In an aspect of the present invention, specific examples of the methyl group-containing polyorganosiloxane include a polyorganosiloxane formed only of D²⁰⁰ unit, a polyorganosiloxane containing D²⁰⁰ unit and Q unit, a polyorganosiloxane containing D²⁰⁰ unit and M unit, a polyorganosiloxane containing D²⁰⁰ unit and T unit, a polyorganosiloxane containing D²⁰⁰ unit, Q unit, and M unit, a polyorganosiloxane containing D²⁰⁰ unit, M unit, and T unit, and a polyorganosiloxane containing D²⁰⁰ unit, Q unit, M unit, and T unit.

In a preferred aspect of the present invention, specific examples of the methyl group-containing polyorganosiloxane include a polyorganosiloxane formed only of D^{2C} unit, a polyorganosiloxane containing D²⁰ unit and Q unit, a polyorganosiloxane containing D²⁰ unit and M unit, a polyorganosiloxane containing D²⁰ unit, T unit, a polyorganosiloxane containing D²⁰ unit, Q unit, and M unit, a polyorganosiloxane containing D²⁰ unit, M unit, and T unit, and a polyorganosiloxane containing D²⁰ unit, Q unit, M unit, and T unit.

Specific examples of the methyl group-containing polyorganosiloxane include, but are not limited to, those represented by formula (M1). 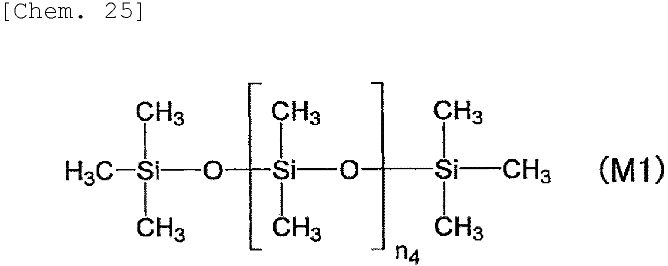 n₄ represents the number of repeating units, and is a positive integer.

Examples of the phenyl group-containing polyorganosiloxane include those containing a siloxane unit (D^{3C} unit) represented by R³¹R³²SiO_{2/2}.

R³¹ is a group bonded to a silicon atom and represents a phenyl group or an alkyl group, R³² is a group bonded to a silicon atom and represents a phenyl group, and specific examples of the alkyl group include the above-described examples, but a methyl group is preferable.

The phenyl group-containing polyorganosiloxane contains the above-described siloxane unit (D³⁰ unit), but may contain Q unit, M unit, and/or T unit in addition to D³⁰ unit.

In a preferred aspect of the present invention, specific examples of the phenyl group-containing polyorganosiloxane include a polyorganosiloxane formed only of D^{3C} unit, a polyorganosiloxane containing D³⁰ unit and Q unit, a polyorganosiloxane containing D³⁰ unit and M unit, a polyorganosiloxane containing D³⁰ unit and T unit, a polyorganosiloxane containing D³⁰ unit, Q unit, and M unit, a polyorganosiloxane containing D³⁰ unit, M unit, and T unit, and a polyorganosiloxane containing D³⁰ unit, Q unit, M unit, and T unit.

Specific examples of the phenyl group-containing polyorganosiloxane include, but are not limited to, those represented by formula (P1) or (P2). 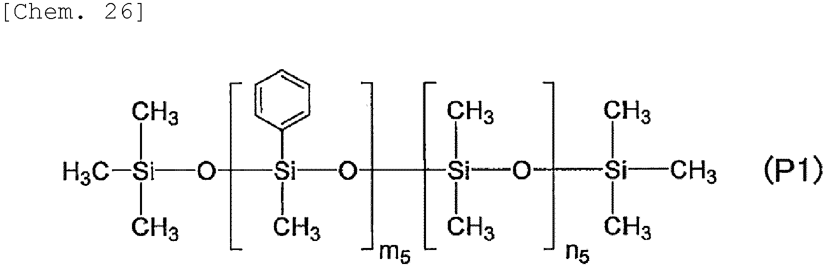 m₅ and n₅ each represent the number of repeating units, and are positive integers. 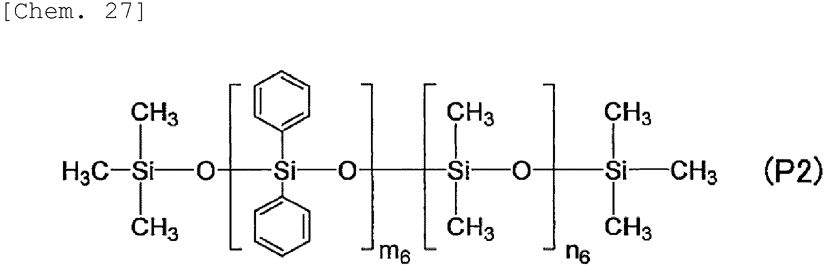 m₆ and n₆ each represent the number of repeating units, and are positive integers.

The polyorganosiloxane as the release agent component (B) may be a commercially available product or a synthetic product.

Examples of the commercially available product of the polyorganosiloxane include, but are not limited to, WACKER SILICONE FLUID AK series (AK 50, AK 350, AK 1000, AK 10000, AK 1000000) and GENIOPLAST GUM, which are products manufactured by Wacker Chemie AG, and dimethyl silicone oil (KF-96L, KF-96A, KF-96, KF-96H, KF-69, KF-965, KF-968) and cyclic dimethyl silicone oil (KF-995) manufactured by Shin-Etsu Chemical Co., Ltd.; epoxy group-containing polyorganosiloxane (trade name: CMS-227, ECMS-327) manufactured by Gelest, Inc., epoxy group-containing polyorganosiloxane (KF-101, KF-1001, KF-1005, X-22-343) manufactured by Shin-Etsu Chemical Co., Ltd., and epoxy group-containing polyorganosiloxane (BY16-839) manufactured by Dow Corning Corporation; and phenyl group-containing polyorganosiloxane (PMM-1043, PMM-1025, PDM-0421, PDM-0821) manufactured by Gelest, Inc, phenyl group-containing polyorganosiloxane (KF50-3000CS) manufactured by Shin-Etsu Chemical Co., Ltd., and phenyl group-containing polyorganosiloxane (TSF 431, TSF 433) manufactured by Momentive Performance Materials, Inc.

The adhesive composition used in the present invention contains the release agent component (B) together with the component (A) that is cured, and in a more preferred aspect, a polyorganosiloxane is contained as the release agent component (B).

In an example of the adhesive composition used in the present invention, the component (A) that is cured and the release agent component (B) can be contained in any ratio, but in consideration of the balance between adhesiveness and releasability, the ratio of the component (A) that is cured and the release agent component (B) is preferably 99.995 : 0.005 to 30 : 70, and more preferably 99.9 : 0.1 to 75 : 25 in mass ratio [(A) : (B)].

That is, when the polyorganosiloxane component (A') that is cured by a hydrosilylation reaction is contained, the ratio of the component (A') to the release agent component (B) is preferably 99.995 : 0.005 to 30 : 70, and more preferably 99.9 : 0.1 to 75 : 25 in mass ratio [(A'): (B)].

The adhesive composition used in the present invention may contain a solvent for the purpose of, for example, adjusting the viscosity, and specific examples thereof include, but are not limited to, aliphatic hydrocarbon, aromatic hydrocarbon, and ketone.

More specific examples of the solvent include, but are not limited to, hexane, heptane, octane, nonane, decane, undecane, dodecane, isododecane, menthane, limonene, toluene, xylene, mesitylene, cumene, MIBK (methyl isobutyl ketone), butyl acetate, diisobutyl ketone, 2-octanone, 2-nonanone, and 5-nonanone. As such a solvent, one type can be used alone or two or more types can be used in combination.

When the adhesive composition used in the present invention contains a solvent, the content thereof is appropriately set in consideration of the desired viscosity of the composition, the coating method to be employed, the thickness of a thin film to be produced, and the like, and is in the range of about 10 to 90 mass% with respect to the entire composition.

The viscosity of the adhesive composition used in the present invention is not particularly limited, and is usually 500 to 20,000 mPa·s, and preferably 1,000 to 5,000 mPa·s at 25°C. The viscosity of the adhesive composition used in the present invention can be adjusted by changing the type of solvent to be used, the ratio thereof, the concentration of the film constituent components, and the like, in consideration of various factors such as the coating method to be used and the desired film thickness.

In the present invention, the term "film constituent components" means components other than a solvent contained in the composition.

In an example of the adhesive composition used in the present invention, the adhesive composition can be produced by mixing the component (A) with the release agent component (B) and a solvent when used.

The mixing order is not particularly limited, and examples of the method capable of producing the adhesive composition for release easily with good reproducibility include, but are not limited to, a method in which the component (A) and the release agent component (B) are dissolved in a solvent, and a method in which the component (A) and the release agent component (B) are partially dissolved in a solvent, the rest are dissolved in a solvent, and the resulting solutions are mixed. Note that when the adhesive composition is prepared, the components may be heated, if appropriate, as long as the components are not decomposed or altered.

In the present invention, in order to remove foreign substances, for example, a solvent to be used or a solution may be filtered using a filter or the like in the middle of production of the adhesive composition or after all the components are mixed.

The thickness of the adhesive layer is not particularly limited, but is preferably 10 to 100 µm and more preferably 20 to 50 µm from the viewpoint of obtaining a good releasing effect with good reproducibility.

### <Releasing and dissolving composition>

The releasing and dissolving composition is a composition for a method for cleaning a semiconductor substrate in order to remove an adhesive layer from the semiconductor substrate.

The releasing and dissolving composition contains a component for releasing the adhesive layer from the semiconductor substrate by swelling the adhesive layer, and a component for dissolving the adhesive layer.

Specifically, the releasing and dissolving composition corresponds to at least one of (i) to (iii) below:
(i) the releasing and dissolving composition contains
   a component [I] below, a component [II] below, and a component [III] below, and
   wherein a content of component [I] is 0.1 to 5 mass%, with respect to the releasing and dissolving composition, and
   with respect to 100 mass% of aprotic solvents in the releasing and dissolving composition, a content of the component [II] is 5 mass% or more and 20 mass% or less, and a content of the component [III] is 60 mass% or more;
(ii) the releasing and dissolving composition contains
   a component [I] below, a component [II] below, a component [III] below, and a component [IV] below,
   the component [IV] contains a solvent represented by formula (L) below, and
   wherein a content of the component [I] is 0.1 to 5 mass%, with respect to the releasing and dissolving composition, and
   with respect to 100 mass% of aprotic solvents in the releasing and dissolving composition, a content of the component [III] is more than 31 mass%, a content of the component [IV] is less than 30 mass%, and a content of the component [II] is 5 mass% or more and 50 mass% or less; and
(iii) the releasing and dissolving composition contains
   a component [I] below, a component [II] below, a component [III] below, and a component [IV] below,
   the component [IV] contains a solvent represented by formula (T) below, and
   wherein a content of the component [I] is 0.1 to 5 mass%, with respect to the releasing and dissolving composition, and
   with respect to 100 mass% of aprotic solvents in the releasing and dissolving composition, a content of the component [III] is more than 31 mass%, a content of the component [IV] is less than 30 mass%, and a content of the component [II] is 5 mass% or and 20 mass% or less,
   in which the component [I] represents a quaternary ammonium salt,
   the component [II] represents an amide-based solvent, which is an acid amide derivative represented by formula (Z) below or a compound represented by formula (Y) below,
   the component [III] represents a solvent represented by formula (G) below,
   the component [IV] represents a solvent represented by formula (T) below or formula (L) below,
   aprotic solvents are solvents having no hydroxyl group (-OH): 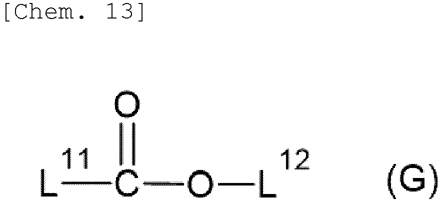
   wherein L¹¹ and L¹² each independently represent an alkyl group having 1 to 6 carbon atoms, and a total number of carbon atoms in the alkyl group of L¹¹ and the alkyl group of L¹² is 7 or less, 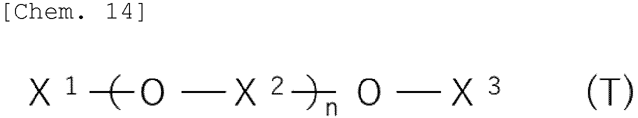
   X¹ and X³ each independently represent an alkyl group or an acyl group (X⁴-C(=O) -), X² represents an alkylene group, n represents 2 or 3, and X⁴ represents an alkyl group,

      [Chem. 15] **L¹-L³-L² (L)**
   wherein L¹ and L² each independently represent an alkyl group having 2 to 5 carbon atoms, and L³ represents O or S, 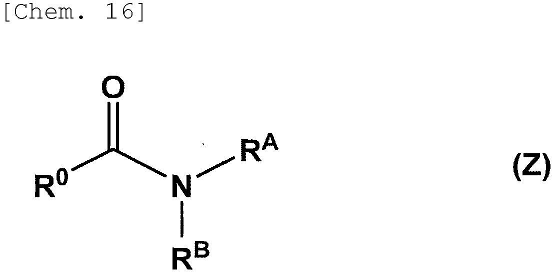
   wherein R⁰ represents an ethyl group, a propyl group, or an isopropyl group, and R^{A} and R^{B} each independently represent an alkyl group having 1 to 4 carbon atoms, 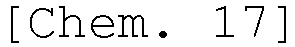 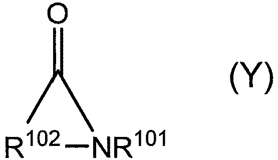
   wherein R¹⁰¹ represents a hydrogen atom or an alkyl group having 1 to 6 carbon atoms, and R¹⁰² represents an alkylene group having 1 to 6 carbon atoms or a group represented by formula (Y1) below: 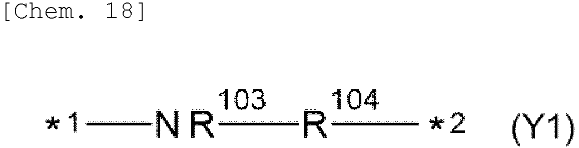
   wherein R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in formula (Y), and *2 represents a bond bonded to a nitrogen atom in formula (Y).

### <<Component [I]: quaternary ammonium salt>>

The quaternary ammonium salt is formed of a quaternary ammonium cation and an anion, and is not particularly limited as long as it is used for this type of application.

The quaternary ammonium salt is effective as a component for dissolving the adhesive layer.

Typical examples of such a quaternary ammonium cation include a tetra (hydrocarbon) ammonium cation. On the other hand, examples of the anion paired therewith include, but are not limited to, a hydroxide ion (OH⁻); a halogen ion (e.g., a fluorine ion (F⁻), a chlorine ion (Cl⁻), a bromine ion (Br⁻), an iodine ion (I⁻)); a tetrafluoroborate ion (BF₄⁻) ; and a hexafluorophosphate ion (PF₆⁻).

The quaternary ammonium salt is preferably a halogen-containing quaternary ammonium salt, and more preferably a fluorine-containing quaternary ammonium salt.

In the quaternary ammonium salt, the halogen atom may be contained in the cation or may be contained in the anion, but is preferably contained in the anion.

In a preferred aspect, the fluorine-containing quaternary ammonium salt is tetra(hydrocarbon)ammonium fluoride.

Specific examples of the hydrocarbon group in tetra(hydrocarbon)ammonium fluoride include an alkyl group having 1 to 20 carbon atoms, an alkenyl group having 2 to 20 carbon atoms, an alkynyl group having 2 to 20 carbon atoms, and an aryl group having 6 to 20 carbon atoms.

In a more preferred aspect, the tetra(hydrocarbon)ammonium fluoride includes tetraalkylammonium fluoride.

Specific examples of the tetraalkylammonium fluoride include, but are not limited to, tetramethylammonium fluoride, tetraethylammonium fluoride, tetrapropylammonium fluoride, and tetrabutylammonium fluoride. Among them, tetrabutylammonium fluoride is preferable.

As the quaternary ammonium salt such as tetra(hydrocarbon)ammonium fluoride, a hydrate may be used. In addition, as the quaternary ammonium salt such as tetra(hydrocarbon)ammonium fluoride, one type may be used alone or two or more types may be used in combination.

The amount of the quaternary ammonium salt is 0.1 to 5 mass% with respect to the releasing and dissolving composition. The quaternary ammonium salt is dissolved in the solvent contained in the releasing and dissolving composition. The quaternary ammonium salt is contained in a small amount because the problem of damage to a dicing tape in a cleaning step described later can be effectively prevented.

### <<Component [II]: amide-based solvent>>

The amide-based solvent is effective as a component for obtaining a releasing and dissolving composition excellent in uniformity by dissolving the quaternary ammonium salt well.

The amide-based solvent is an acid amide derivative represented by formula (Z) below or a compound represented by formula (Y) below.

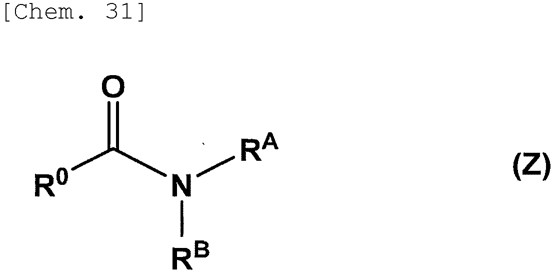

In the formula, R⁰ represents an ethyl group, a propyl group, or an isopropyl group, and is preferably an ethyl group or an isopropyl group, and more preferably an ethyl group. R^{A} and R^{B} each independently represent an alkyl group having 1 to 4 carbon atoms. The alkyl group having 1 to 4 carbon atoms may be linear, branched, or cyclic, and specific examples thereof include a methyl group, an ethyl group, a propyl group, an isopropyl group, a cyclopropyl group, a n-butyl group, an isobutyl group, a s-butyl group, a t-butyl group, and a cyclobutyl group. Among them, R^{A} and R^{B} are preferably a methyl group or an ethyl group, more preferably both are methyl groups or ethyl groups, and still more preferably both are methyl groups.

Examples of the acid amide derivative represented by formula (Z) include N,N-dimethylpropionamide, N,N-diethylpropionamide, N-ethyl-N-methylpropionamide, N,N-dimethylbutyramide, N,N-diethylbutyramide, N-ethyl-N-methylbutyramide, N,N-dimethylisobutyramide, N,N-diethylisobutyramide, and N-ethyl-N-methylisobutyramide. Among them, in particular, N,N-dimethylpropionamide and N,N-dimethylisobutyramide are preferable, and N,N-dimethylpropionamide is more preferable.

The acid amide derivative represented by formula (Z) may be synthesized by a substitution reaction between a corresponding carboxylic acid ester and an amine, or a commercially available product may be used.

Another example of the amide-based solvent is a compound represented by formula (Y) containing a lactam compound or the like.

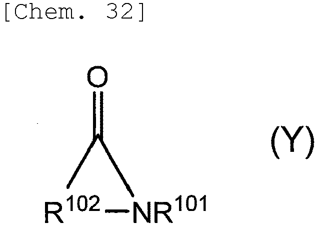

In formula (Y), R¹⁰¹ represents a hydrogen atom or an alkyl group having 1 to 6 carbon atoms, and R¹⁰² represents an alkylene group having 1 to 6 carbon atoms or a group represented by formula (Y1) below.

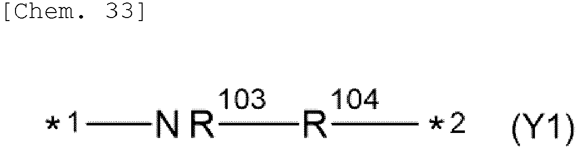

Specific examples of the alkyl group having 1 to 6 carbon atoms of R¹⁰² include a methyl group, an ethyl group, a n-propyl group, and a n-butyl group, and specific examples of the alkylene group having 1 to 6 carbon atoms include a methylene group, an ethylene group, a trimethylene group, a tetramethylene group, a pentamethylene group, and a hexamethylene group, but are not limited thereto.

In formula (Y1), R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in formula (Y), and *2 represents a bond bonded to a nitrogen atom in formula (Y).

Specific examples of the lactam compound represented by formula (Y) include an α-lactam compound, a β-lactam compound, a γ-lactam compound, or a δ-lactam compound, and one type can be used alone or two or more types can be used in combination.

In a preferred aspect, the lactam compound represented by formula (Y) includes 1-alkyl-2-pyrrolidone(N-alkyl-γ-butyrolactam), in a more preferred aspect, N-methylpyrrolidone (NMP) or N-ethylpyrrolidone (NEP), and in a still more preferred aspect, N-methylpyrrolidone (NMP).

In addition, as a preferred aspect of the compound represented by formula (Y), for example, 1,3-dimethyl-2-imidazolidinone can also be mentioned.

Among the components [II], it is more preferable to use the acid amide derivative represented by formula (Z) in consideration of the operational restriction based on the regulations on use for chemical substances.

The content of the amide-based solvent in the releasing and dissolving composition can be set to 50 mass% or less with respect to 100 mass% of aprotic solvents in the releasing and dissolving composition.

The content of the amide-based solvent is 5 mass% or more, preferably 10 mass% or more, and is 50 mass% or less, preferably 40 mass% or less, more preferably 30 mass% or less, and particularly preferably 20 mass% or less with respect to 100 mass% of aprotic solvents, provided that the releasing and dissolving composition is in accordance with the appended claims.

In the present invention, the content of the solvent to be mixed is defined by the ratio with respect to 100 mass% of aprotic solvents that are solvents having no hydroxy group (-OH).

Thus, protic solvents such as water, methanol, and 1-methoxy-2-propanol are not included in the criteria of the content ratio.

In the present invention, the aprotic solvents refer to, for example, N,N-dimethylpropionamide, butyl acetate, dipropylene glycol dimethyl ether, dibutyl ether, and the like, and the mixing ratio can be determined based on the total amount thereof.

### <<Component [III]: solvent represented by formula (G)>>

The solvent represented by formula (G) below is effective as a component for swelling the adhesive layer and releasing the adhesive layer from the semiconductor substrate.

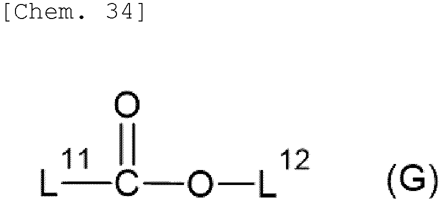

In formula (G), L¹¹ and L¹² each independently represent an alkyl group having 1 to 6 carbon atoms, and a total number of carbon atoms in the alkyl group of L¹¹ and the alkyl group of L¹² is 7 or less.

In formula (G), L¹¹ and L¹² each independently represent an alkyl group having 1 to 6 carbon atoms, and a total number of carbon atoms in the alkyl group of L¹¹ and the alkyl group of L¹² is 7 or less. By setting the number of carbon atoms as described above, release of the adhesive layer in a short time can be realized with good reproducibility.

The alkyl group may be linear, branched, or cyclic, but is preferably a linear or branched alkyl group, and more preferably a linear alkyl group.

Specific examples of the linear or branched alkyl group include, but are not limited to, a methyl group, an ethyl group, a n-propyl group, an i-propyl group, a n-butyl group, an i-butyl group, a s-butyl group, a t-butyl group, a n-pentyl group, a 1-methyl-n-butyl group, a 2-methyl-n-butyl group, a 3-methyl-n-butyl group, a 1,1-dimethyl-n-propyl group, a 1,2-dimethyl-n-propyl group, a 2,2-dimethyl-n-propyl group, a 1-ethyl-n-propyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl -1-methyl-n-propyl group, and a 1-ethyl-2-methyl-n-propyl group.

Specific examples of the cyclic alkyl group include, but are not limited to, cycloalkyl groups such as a cyclopropyl group, a cyclobutyl group, a 1-methyl-cyclopropyl group, a 2-methyl-cyclopropyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, and a 2-ethyl-3-methyl-cyclopropyl group.

From the viewpoint of realizing release of the adhesive layer in a shorter time with good reproducibility, the L¹¹ is preferably a methyl group, and the L¹² is preferably a butyl group or a pentyl group.

Preferred examples of the organic solvent represented by formula (G) include butyl acetate and pentyl acetate from the viewpoint of realizing release of the adhesive layer in a shorter time with good reproducibility, the viewpoint of easy availability of the compound, and the like.

The content of the solvent represented by formula (G) in the releasing and dissolving composition is more than 31 mass% or 60 mass% or more with respect to 100 mass% of aprotic solvents in the releasing and dissolving composition, provided that the releasing and dissolving composition is in accordance with the appended claims.

The content of the solvent represented by formula (G) in the releasing and dissolving composition is preferably more than 35 mass%, more preferably 40 mass% or more, even more preferably 60 mass% or more, particularly preferably 70 mass% or more, and is preferably 90 mass% or less, and more preferably 80 mass% or less with respect to 100 mass% of aprotic solvents in the releasing and dissolving composition. Any combination of these upper and lower limits may be used, provided that the releasing and dissolving composition is in accordance with the appended claims.

An amount of the solvent of the component [IV] represented by formula (T) below or formula (L) below can be incorporated in the releasing and dissolving composition and mixed with the solvent of the component [III] represented by formula (G), and in this case, the sum of the contents of the component [III] and the component [IV] is preferably 30 to 90 mass% with respect to 100 mass% of aprotic solvents.

### <<Component [IV]: solvent represented by formula (T) or formula (L)>>

The solvent represented by formula (T) below or formula (L) below is effective as an adjusting component for enhancing compatibility between the amide-based solvent as the component [II] and the solvent represented by formula (G) as the component [III] and releasability in the releasing and dissolving composition containing the quaternary ammonium salt as the component [I].

In particular, when the component [IV] is a solvent represented by formula (L), the component [IV] has good compatibility with the solvent represented by formula (G) as the component [III], and a releasing and dissolving composition which exhibits the effects of the present invention well can be formed.

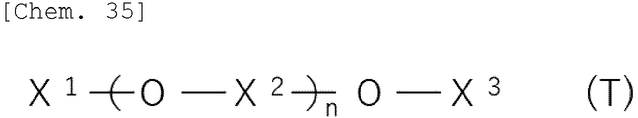

In formula (T), X¹ and X³ each independently represent an alkyl group or an acyl group (X⁴-C(=O)-), X² represents an alkylene group, n represents 2 or 3, and X⁴ represents an alkyl group.

Examples of the alkyl group represented by X₁ and X₃ include an alkyl group having 1 to 4 carbon atoms, and more specific examples thereof include a methyl group, an ethyl group, a propyl group, an isopropyl group, a n-butyl group, an isobutyl group, a sec-butyl group, and a t-butyl group.

Examples of the alkylene group represented by X₂ include a methylene group, a 1,2-ethylene group, a 1,3-propylene group, and a 1,2-propylene group.

Examples of the alkyl group represented by X₄ include an alkyl group having 1 to 4 carbon atoms, and examples thereof include the same alkyl groups as X₁ and X₃.

Preferred examples of the solvent represented by formula (T) include dipropylene glycol dimethyl ether, diethylene glycol dimethyl ether, and diethylene glycol diethyl ether.

[Chem. 36] L¹-L³-L² (L)

In formula (L), L¹ and L² each independently represent an alkyl group having 2 to 5 carbon atoms, and L³ represents O or S.

L¹ and L² may be the same group or different groups, but are preferably the same group from the viewpoint of availability.

The alkyl group having 2 to 5 carbon atoms may be linear, branched, or cyclic, but is preferably a linear or branched alkyl group, and more preferably linear from the viewpoint of realizing release of the adhesive layer in a short time with good reproducibility, and the like.

Specific examples of the linear or branched alkyl group include, but are not limited to, an ethyl group, a n-propyl group, an i-propyl group, a n-butyl group, an i-butyl group, an s-butyl group, a t-butyl group, and a n-pentyl group.

Specific examples of the cyclic alkyl group include, but are not limited to, a cyclopropyl group, a cyclobutyl group, a 1-methyl-cyclopropyl group, a 2-methyl-cyclopropyl group, and a cyclopentyl group.

From the viewpoint of realizing release of the adhesive layer in a short time with good reproducibility, the alkyl group having 2 to 5 carbon atoms is preferably an ethyl group, a n-propyl group, a n-butyl group, or a n-pentyl group, and more preferably an ethyl group, a n-propyl group, or a n-butyl group.

From the viewpoint of realizing release of the adhesive layer in a shorter time with good reproducibility, the viewpoint of easy availability of the compound, and the like, L¹ and L² are preferably the same group.

Preferred examples of the organic solvent represented by formula (L) include di(n-butyl) ether, diethyl ether, di(n-pentyl) ether, and di(n-propyl) sulfide from the viewpoint of realizing release of the adhesive layer in a shorter time with good reproducibility, the viewpoint of easy availability of the compound, and the like.

The content of the solvent represented by formula (T) or formula (L) in the releasing and dissolving composition is less than 30 mass% with respect to 100 mass% of aprotic solvents in the releasing and dissolving composition.

The content of the solvent represented by formula (T) or formula (L) in the releasing and dissolving composition is less than 30 mass%, preferably 25 mass% or less, and more preferably 20 mass% or less with respect to 100 mass% of aprotic solvents in the releasing and dissolving composition.

When the solvent represented by formula (L) is particularly contained as the component IV, the content of the solvent represented by formula (L) in the releasing and dissolving composition is less than 30 mass% with respect to 100 mass% of aprotic solvents in the releasing and dissolving composition.

### <<Releasing and dissolving step>>

In the present invention, the releasing and dissolving composition is continuously brought into contact with the adhesive layer on the semiconductor substrate. By performing this cleaning operation, swelling and release of the adhesive layer and dissolution of the adhesive layer are performed simultaneously. By performing swelling, release, and dissolution of the adhesive layer simultaneously by the cleaning operation using one cleaning composition, the adhesive layer can be removed (cleaned) from the semiconductor substrate more cleanly in a shorter time by a simple cleaning operation.

In the present invention, the removal (cleaning) means that the adhesive layer is removed from the semiconductor substrate, and both a case where the adhesive layer is swollen and released from the semiconductor substrate and a case where the adhesive layer is dissolved in a solution to disappear from the semiconductor substrate are included in the "removal (cleaning)".

The method for continuously bringing the adhesive layer on the semiconductor substrate into contact with the releasing and dissolving composition is not particularly limited as long as the adhesive layer on the semiconductor substrate is in contact with the releasing and dissolving composition with temporal continuity, and the temporal continuity includes not only a case where the adhesive layer is always in contact with the releasing and dissolving composition, but also, for example, a case where contact is made between the adhesive layer and the organic solvent for a certain period of time, and thereafter the contact is stopped once, and then the contact is made again, or this operation is repeated, and also includes not only a case where the entire adhesive layer on the semiconductor substrate is in contact with the releasing and dissolving composition, but also a case where a part of the adhesive layer is in contact with the releasing and dissolving composition, but from the viewpoint of realizing more effective cleaning with good reproducibility, an aspect in which the adhesive layer on the semiconductor substrate is always in contact with the releasing and dissolving composition is preferable, and an aspect in which the entire adhesive layer on the semiconductor substrate is in contact with the releasing and dissolving composition is preferable.

Therefore, in a preferred aspect of the present invention, the adhesive layer on the semiconductor substrate is swollen and dissolved by immersing the adhesive layer in the releasing and dissolving composition, and removed from the semiconductor substrate, or the adhesive layer on the semiconductor substrate is swollen and dissolved by continuously supplying the releasing and dissolving composition onto the adhesive layer and removed from the semiconductor substrate.

In order to immerse the adhesive layer on the semiconductor substrate in the releasing and dissolving composition, for example, the semiconductor substrate with the adhesive layer may be immersed in the releasing and dissolving composition.

The immersion time is defined as the time until swelling and dissolution of the adhesive layer occur and the adhesive layer is released from the semiconductor substrate, and is not particularly limited, but is 5 seconds or more from the viewpoint of realizing more effective cleaning with good reproducibility, and is 5 minutes or less from the viewpoint of throughput in the process.

When the adhesive layer on the semiconductor substrate is immersed in the releasing and dissolving composition, the removal (cleaning) of the adhesive layer may be promoted by moving the semiconductor substrate with the adhesive layer in the releasing and dissolving composition, causing convection of the releasing and dissolving composition, vibrating the releasing and dissolving composition by ultrasonic waves, or the like.

In order to move the semiconductor substrate with the adhesive layer in the releasing and dissolving composition, for example, a swing cleaner, a paddle type cleaner, or the like may be used. When such a cleaner is used, a table on which the semiconductor substrate with the adhesive layer is placed moves or rotates up and down or left and right, so that the adhesive layer on the semiconductor substrate relatively receives convection, or the adhesive layer on the semiconductor substrate receives convection generated by the movement or rotation, and not only swelling and dissolution of the adhesive layer on the semiconductor substrate but also release of the adhesive layer from the semiconductor substrate and dissolution are promoted.

In order to cause convection of the releasing and dissolving composition, for example, in a state where the semiconductor substrate with the adhesive layer is fixed to a stage or the like, a convection cleaner capable of realizing a state where the releasing and dissolving composition around the semiconductor substrate is circulated by convection with a stirrer may be typically used other than the swing cleaner and the paddle type cleaner described above.

In order to vibrate the releasing and dissolving composition by ultrasonic waves, an ultrasonic cleaner or an ultrasonic probe may be used, and the conditions thereof are usually 20 kHz to 5 MHz.

In order to continuously supply the releasing and dissolving composition onto the adhesive layer on the semiconductor substrate, the releasing and dissolving composition may be continuously applied to the adhesive layer on the semiconductor substrate. As an example, when the adhesive layer on the semiconductor substrate faces upward, for example, a rod-like or atomized, preferably rod-like releasing and dissolving composition is supplied with temporal continuity onto the adhesive layer on the semiconductor substrate from above (including obliquely above) the adhesive layer on the semiconductor substrate by a nozzle or the like of a cleaning apparatus. The temporal continuity in this case also includes not only a case where the releasing and dissolving composition is always supplied onto the adhesive layer on the semiconductor substrate, but also, for example, a case where supply of the releasing and dissolving composition is performed for a certain period of time, and thereafter the supply is stopped once, and then the supply is performed again, or this operation is repeated but from the viewpoint of realizing more effective cleaning with good reproducibility, it is preferable that the releasing and dissolving composition is always supplied onto the adhesive layer on the semiconductor substrate.

When the releasing and dissolving composition is supplied in a rod-like shape onto the adhesive layer on the semiconductor substrate, the flow rate is usually 200 to 500 mL/min.

In an aspect of the present invention, in order to realize a state of always being in contact with the releasing and dissolving composition, the adhesive layer on the semiconductor substrate may be brought into contact with the vapor of the releasing and dissolving composition using, for example, a steam cleaner.

When the method for cleaning a semiconductor of the present invention is used, as described above, by performing swelling, release, and dissolution of the adhesive layer simultaneously, the adhesive layer can be removed (cleaned) from the semiconductor substrate more cleanly in a shorter time by a simple cleaning operation. In addition to this effect, when the method for cleaning a semiconductor of the present invention is used, damage to a dicing tape in the cleaning step can be prevented.

For example, after a semiconductor wafer is polished and thinned, the semiconductor wafer after thinning is mounted on a dicing tape, and then the semiconductor wafer and the support are separated (released). After the support is separated (released), the adhesive layer remaining on the semiconductor wafer side is cleaned with the cleaning agent composition for removal from the semiconductor wafer. At that time, when a cleaning agent composition of a type that dissolves and removes an adhesive residue such as the cleaning agent compositions of Patent Literatures 1 and 2 is used as the cleaning agent composition, the surface of the dicing tape changes, and the dicing tape is damaged.

However, when the semiconductor substrate with the adhesive layer is cleaned using the releasing and dissolving composition of the present invention, most of the adhesive layer can be released in a short time, and a small amount of the adhesive layer remaining after release is also dissolved by the dissolving component in the releasing and dissolving composition, so that the entire removal (cleaning) time for removing the adhesive layer is short, and the damage to the dicing tape in the cleaning step can be effectively prevented. In addition, the releasing and dissolving composition of the present invention contains not only a component for dissolving the adhesive layer but also a component for swelling and releasing the adhesive layer, and as a result, the proportion of the dissolving component, that is, the component [I] (quaternary ammonium salt) in the composition can be reduced, which also effectively contributes to preventing damage to the dicing tape.

When the step of removing the adhesive layer is performed using the releasing and dissolving composition of the present invention, damage to the dicing tape can be effectively prevented.

The method for cleaning a semiconductor substrate of the present invention may include a step of eliminating the released adhesive layer.

The method for eliminating the released adhesive layer is not particularly limited as long as the adhesive layer released from the semiconductor substrate is removed, and when the semiconductor substrate with the adhesive layer is immersed in the releasing and dissolving composition, the released adhesive layer present in the releasing and dissolving composition may be removed without taking out the semiconductor substrate from the releasing and dissolving composition. Alternatively, the semiconductor substrate may be taken out from the releasing and dissolving composition, and the released adhesive layer may be removed by separating the semiconductor substrate from the released adhesive layer. At this time, by simply taking out the semiconductor substrate from the releasing and dissolving composition, the released adhesive layer may naturally remain in the releasing and dissolving composition, and most of the adhesive layer can be eliminated in some cases.

Specific examples of the method for eliminating the released adhesive layer include, but are not limited to, a method for eliminating the released adhesive layer by adsorbing and sucking the adhesive layer using a device, a method for eliminating the released adhesive layer by blowing off the adhesive layer with gas such as an air gun, and a method for eliminating the released adhesive layer by centrifugal force or the like by moving or rotating the semiconductor substrate vertically or horizontally.

After the adhesive layer released from the semiconductor substrate is removed, if necessary, the semiconductor substrate is dried or the like according to a standard method.

### (Releasing and dissolving composition)

The releasing and dissolving composition used in the method for cleaning a semiconductor substrate of the present invention is also an object of the present invention.

The releasing and dissolving composition of the present invention is used for removing (cleaning) an adhesive layer on a semiconductor substrate from the semiconductor substrate, and preferred aspects and conditions are as described above. The releasing and dissolving composition of the present invention can be produced by mixing a solvent constituting the composition in any order as necessary. At that time, if necessary, filtration or the like may be performed.

Embodiments of the releasing and dissolving composition of the present invention are a releasing and dissolving composition which corresponds to at least one of (i) to (iii) below.
(i) A releasing and dissolving composition contains a component [I], a component [II], and a component [III], a content of component [I] is 0.1 to 5 mass%, with respect to the releasing and dissolving composition, and
   with respect to 100 mass% of aprotic solvents, a content of the component [II] is 5 mass% or more and 20 mass% or less, and a content of the component [III] is 60 mass% or more.
(ii) A releasing and dissolving composition contains a component [I], a component [II], a component [III], and a component [IV],
   the component [IV] contains a solvent represented by formula (L), a content of component [I] is 0.1 to 5 mass%, with respect to the releasing and dissolving composition, and
   with respect to 100 mass% of aprotic solvents, a content of the component [III] is more than 31 mass%, a content of the component [IV] is less than 30 mass%, and a content of the component [II] is 5 mass% or more and 50 mass% or less.
   In addition, a preferred embodiment of (ii) includes a releasing and dissolving composition containing a component [I], a component [II], a component [III], and a component [IV], in which the component [IV] contains a solvent represented by formula (L), a content of the component [I] is 0.1 to 5 mass%, with respect to the releasing and dissolving composition, and with respect to 100 mass% of aprotic solvents, a content of the component [III] is more than 35 mass%, a content of the component [IV] is less than 30 mass%, and a content of the component [II] is 5 mass% or more and 50 mass% or less.
(iii) A releasing and dissolving composition contains a component [I], a component [II], a component [III], and a component [IV],
   the component [IV] contains a solvent represented by formula (T), a content of the component [I] is 0.1 to 5 mass%, with respect to the releasing and dissolving composition, and
   with respect to 100 mass% of aprotic solvents, a content of the component [III] is more than 31 mass%, a content of the component [IV] is less than 30 mass%, and a content of the component [II] is 5 mass% or more and 20 mass% or less.
   In particular, when a releasing and dissolving composition contains a component [I], a component [II], a component [III], and a component [IV], and the component [IV] is a solvent represented by formula (L), the composition containing, for example, the component [II] in an amount of 30 mass% or more and 50 mass% or less, the component [III] in an amount of more than 31 mass% and 50 mass% or less, and the component [IV] in an amount of 10 mass% or more and less than 30 mass% with respect to 100 mass% of aprotic solvents also shows good results.

### (Method for producing processed semiconductor substrate)

When the method for cleaning a semiconductor substrate of the present invention described above is used, it is possible to efficiently remove an adhesive layer on a substrate of a semiconductor substrate, particularly an adhesive layer which is a cured film obtained from a siloxane-based adhesive containing a polyorganosiloxane component (A') that is cured by a hydrosilylation reaction, and it is possible to expect highly efficient and good production of a semiconductor element.

In the method for producing a processed semiconductor substrate of the present invention, for example, after a semiconductor wafer is polished and thinned, a support is separated (released) from the processed semiconductor wafer after thinning, and then an adhesive layer remaining on the semiconductor wafer side is removed (cleaned) using the method for cleaning a semiconductor substrate of the present invention, whereby a processed semiconductor substrate having a cleaned surface with no residual adhesive layer can be produced.

As described above, examples of use of the method for cleaning a semiconductor substrate of the present invention in a semiconductor process include use in a method for producing a processed semiconductor substrate such as thinning used in a semiconductor packaging technique such as TSV.

In addition to a silicon semiconductor substrate such as a silicon wafer described above, the semiconductor substrate to be cleaned by the cleaning method of the present invention includes various substrates such as a germanium substrate, a gallium-arsenic substrate, a gallium-phosphorus substrate, a gallium-arsenic-aluminum substrate, an aluminum-plated silicon substrate, a copper-plated silicon substrate, a silver-plated silicon substrate, a gold-plated silicon substrate, a titanium-plated silicon substrate, a silicon nitride film-formed silicon substrate, a silicon oxide film-formed silicon substrate, a polyimide film-formed silicon substrate, a glass substrate, a quartz substrate, a liquid crystal substrate, and an organic EL substrate.

A preferred embodiment of the method for producing a processed semiconductor substrate of the present invention includes
a method for producing a processed semiconductor substrate, the method including:
a first step: a step of producing a laminate including a semiconductor substrate, a support substrate, and an adhesive layer obtained from an adhesive composition;
a second step: a step of processing the semiconductor substrate of the obtained laminate;
a third step: a step of separating the semiconductor substrate and the adhesive layer from the support substrate; and
a fourth step: a step of releasing and dissolving the adhesive layer on the semiconductor substrate using a releasing and dissolving composition to remove the adhesive layer.

Here, the releasing and dissolving composition is as described in the section of <Releasing and dissolving composition> above.

In the fourth step, the method for cleaning a semiconductor substrate of the present invention is used.

Hereinafter, the respective steps will be described in detail.

### <First step>

As the adhesive composition used for forming the adhesive layer in the first step, the above-described various adhesives can be used, but the method for cleaning a semiconductor substrate of the present invention is effective in removing the adhesive layer obtained from a polysiloxane-based adhesive, and is more effective in removing the adhesive layer obtained from a polysiloxane-based adhesive containing the component (A) that is cured by a hydrosilylation reaction.

Therefore, an example in which when a processed semiconductor substrate is produced using the adhesive layer obtained using a polysiloxane-based adhesive (adhesive composition), the adhesive layer is removed by the cleaning method of the present invention will be described below, but the present invention is not limited thereto.

A first step of producing a laminate including a semiconductor substrate, a support substrate, and an adhesive layer obtained from an adhesive composition will be described below.

In an aspect, the first step includes a step of coating a surface of a semiconductor substrate or a support substrate with an adhesive composition to form an adhesive coating layer, and a step of combining the semiconductor substrate and the support substrate with the adhesive coating layer interposed therebetween, bringing the semiconductor substrate and the support substrate into close contact with each other by applying a load in a thickness direction of the semiconductor substrate and the support substrate while performing at least one of a heating treatment and a decompression treatment, and then performing a post-heating treatment to form a laminate.

In another aspect, the first step includes, for example, a step of coating a circuit surface of a wafer of a semiconductor substrate with an adhesive composition and heating the adhesive composition to form an adhesive coating layer, a step of coating a surface of a support substrate with a release agent composition and heating the release agent composition to form a release agent coating layer, and a step of bringing the adhesive coating layer of the semiconductor substrate and the release agent coating layer of the support substrate into close contact with each other by applying a load in a thickness direction of the semiconductor substrate and the support substrate while performing at least one of a heating treatment and a decompression treatment, and then performing a post-heating treatment to form a laminate. Although the adhesive composition and the release agent composition are applied to the semiconductor substrate and the support substrate, respectively, and heated, the application and heating of the adhesive composition and the release agent composition may be sequentially performed on either one of the substrates.

In each of the above aspects, which treatment condition of the heating treatment, the decompression treatment, or both in combination, is adopted is appropriately determined in consideration of various circumstances such as the type of the adhesive composition, the specific formulation of the release agent composition, the compatibility of the films obtained from both compositions, the film thickness, and the required adhesive strength.

Here, for example, the semiconductor substrate is a wafer, and the support substrate is a support. The object to be coated with the adhesive composition may be either one or both of the semiconductor substrate and the support substrate.

Examples of the wafer include, but are not limited to, a silicon wafer and a glass wafer having a diameter of about 300 mm and a thickness of about 770 µm.

In particular, the method for cleaning a semiconductor substrate of the present invention enables effective cleaning of a substrate also for a semiconductor substrate with bumps.

Specific examples of such a semiconductor substrate with bumps include a silicon wafer with bumps such as ball bumps, printed bumps, stud bumps, or plated bumps, and usually, the semiconductor substrate with bumps is appropriately selected from the conditions of a bump height of about 1 to 200 µm, a bump diameter of 1 to 200 µm, and a bump pitch of 1 to 500 µm.

Specific examples of the plated bumps include, but are not limited to, Sn-based alloy plating such as SnAg bumps, SnBi bumps, Sn bumps, and AuSn bumps.

The support (carrier) is not particularly limited, and examples thereof include, but are not limited to, a silicon wafer having a diameter of about 300 mm and a thickness of about 700 µm.

Examples of the release agent composition include a composition containing a release agent component used for this type of application.

The coating method is not particularly limited, and is usually a spin coating method. A method for separately forming a coating film by a spin coating method or the like and bonding the coating film in a sheet-like form may be adopted, which is also referred to as coating or a coating film.

The heating temperature of the applied adhesive composition varies depending on the type and amount of the adhesive component contained in the adhesive composition, whether or not a solvent is contained, the desired thickness of the adhesive layer, and the like, and thus cannot be unconditionally defined, but is usually 80 to 150°C, and the heating time is usually 30 seconds to 5 minutes.

The heating temperature of the applied release agent composition varies depending on the type and amount of the crosslinking agent, the acid generator, the acid, and the like, whether or not a solvent is contained, the desired thickness of the release layer, and the like, and thus cannot be unconditionally defined, but is 120°C or higher from the viewpoint of realizing suitable curing, and is preferably 260°C or lower from the viewpoint of preventing excessive curing, and the heating time is usually 1 to 10 minutes.

The heating can be performed using a hot plate, an oven, or the like.

The film thickness of the adhesive coating layer obtained by applying the adhesive composition and heating the adhesive composition is usually 5 to 500 µm.

The film thickness of the release agent coating layer obtained by applying the release agent composition and heating the release agent composition is usually 5 to 500 µm.

The heating treatment is usually appropriately determined from the range of 20 to 150°C from the viewpoint of softening the adhesive coating layer to realize suitable bonding with the release agent coating layer, the viewpoint of realizing suitable curing of the release agent coating layer, and the like. In particular, from the viewpoint of preventing or avoiding excessive curing or unnecessary alteration of the adhesive component or the release agent component, the heating temperature is preferably 130°C or lower, more preferably 90°C or lower, and the heating time is usually 30 seconds or more, and preferably 1 minute or more from the viewpoint of reliably exhibiting an adhesive ability and a releasing ability, and is usually 10 minutes or less, and preferably 5 minutes or less from the viewpoint of preventing alteration of the adhesive layer or other members.

In the decompression treatment, the semiconductor substrate, the adhesive coating layer, and the support substrate, or the semiconductor substrate, the adhesive coating layer, the release agent coating layer, and the support substrate may be exposed to an air pressure of 10 to 10,000 Pa. The time for the decompression treatment is usually 1 to 30 minutes.

In a preferred aspect of the present invention, the substrate and the coating layer or the coating layers are bonded to each other preferably by a decompression treatment, more preferably by a combination of a heating treatment and a decompression treatment.

The load in the thickness direction of the semiconductor substrate and the support substrate is not particularly limited as long as the load does not adversely affect the semiconductor substrate, the support substrate, and the layers therebetween, and can bring these into close contact with one another, and is usually in the range of 10 to 1,000 N.

The post-heating temperature is preferably 120°C or higher from the viewpoint of obtaining a sufficient curing rate, and is preferably 260°C or lower from the viewpoint of preventing alteration of the substrate, the adhesive component, the release agent component, and the like. The heating time is usually 1 minute or more from the viewpoint of realizing suitable bonding of wafers by curing, and is preferably 5 minutes or more from the viewpoint of stabilizing the physical properties of the adhesive, and the like, and is usually 180 minutes or less, and preferably 120 minutes or less from the viewpoint of avoiding, for example, an adverse effect on the adhesive layer due to excessive heating. The heating can be performed using a hot plate, an oven, or the like.

One object of the post-heating treatment is to more suitably cure the adhesive component (S).

### <Second step>

Next, the second step of processing the semiconductor substrate of the laminate obtained by the method described above will be described.

Examples of the processing applied to the laminate used in the present invention include processing of the back surface opposite to the circuit surface of the front surface of the semiconductor substrate, and typically include thinning of a wafer by polishing the back surface of the wafer. A through silicon via (TSV) or the like is formed using such a thinned wafer, and then the thinned wafer is released from the support to form a laminate of wafers, which is three-dimensionally mounted. Before and after that, a wafer back electrode or the like is also formed. Heat at 250 to 350°C is applied for the thinning of the wafer and the TSV process in a state of being adhered to the support, and the adhesive layer included in the laminate used in the present invention has heat resistance to the heat.

For example, a wafer having a diameter of about 300 mm and a thickness of about 770 µm can be thinned to a thickness of about 80 to 4 µm by polishing the back surface opposite to the circuit surface of the front surface.

### <Third step>

The third step of separating the processed semiconductor substrate and the adhesive layer from the support substrate will be described.

In the third step, the processed semiconductor substrate and the adhesive layer are separated from the support substrate. At this time, when the release layer is included in the laminate, usually, the release layer is also removed together with the support substrate.

In a method for separating the processed semiconductor substrate and the adhesive layer from the semiconductor substrate, it is only necessary to release the adhesive layer from the release layer or the support substrate in contact with the adhesive layer, and examples of such a releasing method include, but are not limited to, laser releasing, mechanical releasing with machinery having a sharp portion, and manual releasing.

### <Fourth step>

Next, the fourth step of removing the adhesive layer on the processed semiconductor substrate and cleaning the processed semiconductor substrate will be described.

The fourth step is a step of eliminating the adhesive layer on the semiconductor substrate by the method for cleaning a semiconductor substrate of the present invention, and specifically, for example, the adhesive layer on the thinned substrate is cleanly removed in a short time by the cleaning method of the present invention. Various conditions at this time are as described above.

As described above, swelling and dissolution act simultaneously on the adhesive layer only by performing a cleaning operation using the releasing and dissolving composition of the present invention, and thus, in the fourth step, the adhesive layer on the semiconductor substrate can be removed more cleanly in a short time.

The method for producing a processed semiconductor substrate of the present invention includes the first step to the fourth step described above, but may include steps other than these steps. The constituent elements and method elements related to the first step to the fourth step may be variously changed without departing from the gist of the present invention.

### Examples

Hereinafter, the contents and effects of the present invention will be described in more detail by way of examples, but the present invention is not limited thereto. The apparatus used is as follows.

### [Apparatus]

(1) Stirrer A: rotation and revolution mixer ARE-500, manufactured by THINKY CORPORATION
(2) Stirrer B: mixing rotor VMR-5R, manufactured by AS ONE Corporation
(3) Viscometer: rotation viscometer TVE-22H, manufactured by Toki Sangyo Co., Ltd.
(4) Optical microscope: semiconductor/FPD inspection microscope MX61L, manufactured by Olympus Corporation

### [1] Preparation of adhesive composition 1

### [Example 1]

In a 600 mL stirring container dedicated to the stirrer A, 230.01 g of a p-menthane solution (concentration: 81.7 mass%) of an MQ resin (manufactured by Wacker Chemie AG) having a polysiloxane skeleton and a vinyl group as the component (a1), 78.06 g of a polyorganosiloxane represented by formula (M1) as the component (B) (complex viscosity: 6,000 Pa·s, weight average molecular weight: 642,000 (dispersity: 2.6), manufactured by Wacker Chemie AG, trade name: GENIOPLAST GUM), 164.62 g of p-menthane (manufactured by Nippon Terpene Chemicals, Inc.), and 23.13 g of n-decane (manufactured by SANKYO CHEMICAL CO., LTD.) were added, and stirring with the stirrer A for 5 minutes was repeated a total of 8 times with a short break in between to obtain a mixture (I) (total stirring time: 40 minutes).

To the obtained mixture (I), 37.58 g of SiH group-containing linear polydimethylsiloxane (manufactured by Wacker Chemie AG) having a viscosity of 100 mPa·s as the component (a2) and 54.93 g of vinyl group-containing linear polydimethylsiloxane (manufactured by Wacker Chemie AG) having a viscosity of 200 mPa·s as the component (a1) were added to obtain a mixture (II).

As the component (A3), 0.87 g of 1,1-diphenyl-2-propyn-1-ol (manufactured by Tokyo Chemical Industry Co., Ltd.), as the component (A3), 0.87 g of 1-ethynyl-1-cyclohexanol (manufactured by Wacker Chemie AG), and 1.73 g of p-menthane (manufactured by Nippon Terpene Chemicals, Inc.) were stirred with the stirrer B for 60 minutes to obtain a mixture (III).

To the mixture (II), 2.89 g of the obtained mixture (III) was added, and the mixture was stirred with the stirrer A for 5 minutes to obtain a mixture (IV).

As the component (A2), 0.139 g of a platinum catalyst (manufactured by Wacker Chemie AG) and as the component (a1), 10.41 g of a vinyl group-containing linear polydimethylsiloxane (manufactured by Wacker Chemie AG) having a viscosity of 1,000 mPa·s were stirred with the stirrer A for 5 minutes to obtain a mixture (V).

To the mixture (IV), 8.79 g of the obtained mixture (V) was added, and the mixture was stirred with the stirrer A for 5 minutes to obtain a mixture (VI).

Finally, the obtained mixture (VI) was filtered through a 300-mesh nylon filter to obtain an adhesive composition. In addition, the viscosity of the obtained adhesive composition was 2,500 mPa·s.

### [2] Cleaning composition

### [Example 2-1]

To 0.42 g of tetrabutylammonium fluoride trihydrate (manufactured by KANTO CHEMICAL CO., INC.), 1.40 g of N-methyl-2-pyrrolidone, 9.80 g of butyl acetate, and 2.80 g of dipropylene glycol dimethyl ether were added, followed by stirring to obtain a cleaning composition.

### [Example 2-2] to [Example 2-5], [Comparative Example 1-1] to [Comparative Example 1-8]

Cleaning compositions were obtained in the same manner as in Example 2-1 except that adjustment was made to provide the formulations in Tables 1 to 3 (Tables 1 to 3 are also collectively referred to as Table 1 and the like).

### [Example 2-6] to [Example 2-8]

Cleaning compositions were obtained in the same manner as in Example 2-1 except that N-ethyl-2-pyrrolidone was used in place of N-methyl-2-pyrrolidone as the N-substituted amide compound of the component II and adjustment was made to provide the formulations in Table 1 and the like.

### [Example 2-9] to [Example 2-11]

Cleaning compositions were obtained in the same manner as in Example 2-1 except that N,N-dimethylpropionamide was used in place of N-methyl-2-pyrrolidone as the N-substituted amide compound of the component II and adjustment was made to provide the formulations in Table 1 and the like.

### [Example 2-12] to [Example 2-14]

Cleaning compositions were obtained in the same manner as in Example 2-1 except that 1,3-dimethyl-2-imidazolidinone was used in place of N-methyl-2-pyrrolidone as the N-substituted amide compound of the component II and adjustment was made to provide the formulations in Table 1 and the like.

### [Example 2-15] to [Example 2-16]

Cleaning compositions were obtained in the same manner as in Example 2-1 except that dibutyl ether was used in place of dipropylene glycol dimethyl ether as the IV component and adjustment was made to provide the formulations in Table 1 and the like.

### [3] Preparation of substrate for evaluation

### [Production Example 1]

The adhesive composition obtained in Example 1 was applied by spin coating to a 4 cm × 4 cm silicon wafer (thickness: 775 µm) as a device-side wafer, and heated at 110°C for 1.5 minutes (pre-heating treatment), and then heated at 200°C for 10 minutes to remove a residual solvent on the wafer and form a thin film having a thickness of about 40 µm on the wafer, thereby obtaining a wafer with an adhesive layer.

### [4] Measurement of release time

The wafer with an adhesive layer prepared in Production Example 1 was immersed in 7 mL of each of the cleaning compositions obtained in Examples 2-1 to 2-16 and Comparative Examples 1-1 to 1-8. The time until the adhesive layer was completely released from the wafer was defined as the release time. The results are shown in the following Tables 1 to 3. In Comparative Examples 1-1 and 1-2, turbidity occurred after addition of TBAF in the test of [4], and therefore the test of [4] was not performed (indicated as N.A. in the table).

### [5] Observation of presence or absence of residue after release

The wafer with an adhesive layer prepared in Production Example 1 was immersed in 7 mL of each of the cleaning compositions obtained in Examples 2-1 to 2-16 and Comparative Examples 1-1 to 1-8. When the adhesive layer was released within 1 minute after immersion in the cleaning composition, the released adhesive layer was removed with forceps. The substrate was left for 1 minute from the start of immersion, and then cleaned with isopropanol and ultrapure water, and the presence or absence of a residue on the substrate was observed with an optical microscope. The results are shown in the following Tables 1 to 3. In Comparative Examples 1-1 and 1-2, turbidity occurred after addition of TBAF in the test of [4], and therefore the test of [5] was not performed (indicated as N.A. in the table). In addition, in Comparative Examples 1-3 to 1-6, release did not occur even after 300 seconds in the test of [4], and therefore the test of [5] was not performed (indicated as N.A. in the table).

It has been found that when the semiconductor substrate with an adhesive layer is cleaned using the releasing and dissolving composition of the present invention, the adhesive layer can be removed (cleaned) from the semiconductor substrate in a short time as shown in Examples 2-1 to 2-16. In the present invention, most of the adhesive layer can be released in a short time, even if a small amount of the adhesive layer remains after release, the adhesive residue is dissolved by the dissolving component in the releasing and dissolving composition, and is cleanly removed. This is also shown by the results of Examples 2-1 to 2-16, and as shown in Examples 2-1 to 2-16, the adhesive layer on the semiconductor substrate could be cleanly removed only by immersing the semiconductor substrate in the releasing and dissolving composition of the present invention for a short time of 1 minute.

That is, when the method for cleaning a semiconductor substrate of the present invention is used, it is possible to remove (clean) the adhesive layer from the semiconductor substrate having the adhesive layer on the surface thereof more cleanly in a shorter time by a simple operation.

**[Table 1]**

| | Formulation | | | | | | | | Release time (sec) | Residue after release |
|---|---|---|---|---|---|---|---|---|---|---|
| | Component II: N-substituted amide compound (%) | | | | Component III: ester (%) | Component IV (%) | | TBAF (phr with respect to total amount of solvent) | | |
| | N-Methyl-2-pyrrolidone | N-Ethyl-2-pyrrolidone | N,N-Dimethylpropionamide | 1,3-Dimethyl-2-imidazolidinone | Butyl acetate | Dipropylene glycol dimethyl ether | Dibutyl ether | | | |
| Example 2-1 | 10 | | | | 70 | 20 | | | 21 | Absent |
| Example 2-2 | 10 | | | | 90 | 0 | | | 15 | Absent |
| Example 2-3 | 20 | | | | 60 | 20 | | | 50 | Absent |
| Example 2-4 | 20 | | | | 70 | 10 | | 3 | 60 | Absent |
| Example 2-5 | 20 | | | | 80 | 0 | | | 28 | Absent |
| Example 2-6 | | 10 | | | 70 | 20 | | | 19 | Absent |
| Example 2-7 | | 20 | | | 70 | 10 | | | 29 | Absent |
| Example 2-8 | | 20 | | | 80 | 0 | | | 23 | Absent |

**[Table 2]**

| | Formulation | | | | | | | | Release time (sec) | Residue after release |
|---|---|---|---|---|---|---|---|---|---|---|
| | Component II: N-substituted amide compound (%) | | | | Component III: ester (%) | Component IV (%) | | TBAF (phr with respect to total amount of solvent) | | |
| | N-Methyl-2-pyrrolidone | N-Ethyl-2-pyrrolidone | N,N-Dimethylpropionamide | 1,3-Dimethyl-2-imidazolidinone | Butyl acetate | Dipropylene glycol dimethyl ether | Dibutyl ether | | | |
| Example 2-9 | | | 10 | | 70 | 20 | | | 20 | Absent |
| Example 2-10 | | | 20 | | 70 | 10 | | | 31 | Absent |
| Example 2-11 | | | 20 | | 80 | 0 | | | 26 | Absent |
| Example 2-12 | | | | 10 | 70 | 20 | | 3 | 21 | Absent |
| Example 2-13 | | | | 20 | 70 | 10 | | | 37 | Absent |
| Example 2-14 | | | | 20 | 80 | 0 | | | 33 | Absent |
| Example 2-15 | 20 | | | | 70 | | 10 | | 17 | Absent |
| Example 2-16 | 40 | | | | 40 | | 20 | | 32 | Absent |

**[Table 3]**

| | Formulation | | | | | | | | Release time (sec) | Residue after release |
|---|---|---|---|---|---|---|---|---|---|---|
| | Component II: N-substituted amide compound (%) | | | | Component III: ester (%) | Component IV (%) | | TBAF (phr with respect to total amount of solvent) | | |
| | N-Methyl-2-pyrrolidone | N-Ethyl-2-pyrrolidone | N,N-Dimethylpropionamide | 1,3-Dimethyl-2-imidazolidinone | Butyl acetate | Dipropylene glycol dimethyl ether | Dibutyl ether | | | |
| Comparative Example 1-1 | 0 | | | | 50 | 50 | | 3 | N.A. | N.A. |
| Comparative Example 1-2 | 0 | | | | 100 | 0 | | | N.A. | N.A. |
| Comparative Example 1-3 | 10 | | | | 20 | 70 | | | 300 < | N.A. |
| Comparative Example 1-4 | 20 | | | | 50 | 30 | | | 300 < | N.A. |
| Comparative Example 1-5 | 30 | | | | 60 | 10 | | | 300 < | N.A. |
| Comparative Example 1-6 | 40 | | | | 60 | 0 | | | 300 < | N.A. |
| Comparative Example 1-7 | 20 | | | | 60 | 20 | | 0 | 35 | Present |
| Comparative Example 1-8 | 20 | | | | 70 | 10 | | | 31 | Present |

## Claims

1. A method for cleaning a semiconductor substrate, the method comprising a step of releasing and dissolving an adhesive layer formed on a semiconductor substrate using a releasing and dissolving composition,
wherein the releasing and dissolving composition corresponds to at least one of (i) to (iii) below:
(i) the releasing and dissolving composition contains
a component [I] below, a component [II] below, and a component [III] below, and
wherein a content of component [I] is 0.1 to 5 mass%, with respect to the releasing and dissolving composition, and
with respect to 100 mass% of aprotic solvents in the releasing and dissolving composition, a content of the component [II] is 5 mass% or more and 20 mass% or less, and a content of the component [III] is 60 mass% or more;
(ii) the releasing and dissolving composition contains
a component [I] below, a component [II] below, a component [III] below, and a component [IV] below,
the component [IV] contains a solvent represented by formula (L) below, and
wherein a content of the component [I] is 0.1 to 5 mass%, with respect to the releasing and dissolving composition, and
with respect to 100 mass% of aprotic solvents in the releasing and dissolving composition, a content of the component [III] is more than 31 mass%, a content of the component [IV] is less than 30 mass%, and a content of the component [II] is 5 mass% or more and 50 mass% or less; and
(iii) the releasing and dissolving composition contains
a component [I] below, a component [II] below, a component [III] below, and a component [IV] below,
the component [IV] contains a solvent represented by formula (T) below, and
wherein a content of the component [I] is 0.1 to 5 mass%, with respect to the releasing and dissolving composition, and
with respect to 100 mass% of aprotic solvents in the releasing and dissolving composition, a content of the component [III] is more than 31 mass%, a content of the component [IV] is less than 30 mass%, and a content of the component [II] is 5 mass% or and 20 mass% or less,
in which the component [I] represents a quaternary ammonium salt,
the component [II] represents an amide-based solvent, which is an acid amide derivative represented by formula (Z) below or a compound represented by formula (Y) below,
the component [III] represents a solvent represented by formula (G) below,
the component [IV] represents a solvent represented by formula (T) below or formula (L) below, and
aprotic solvents are solvents having no hydroxyl group (-OH) : 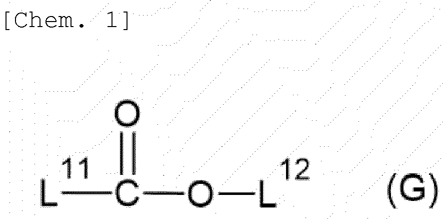
wherein L¹¹ and L¹² each independently represent an alkyl group having 1 to 6 carbon atoms, and a total number of carbon atoms in the alkyl group of L¹¹ and the alkyl group of L¹² is 7 or less, 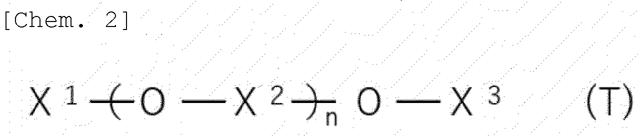
X¹ and X³ each independently represent an alkyl group or an acyl group (X⁴-C(=O)-), X² represents an alkylene group, n represents 2 or 3, and X⁴ represents an alkyl group,
[Chem. 3] **L¹-L³-L² (L)**
wherein L¹ and L² each independently represent an alkyl group having 2 to 5 carbon atoms, and L³ represents O or S, 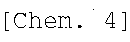 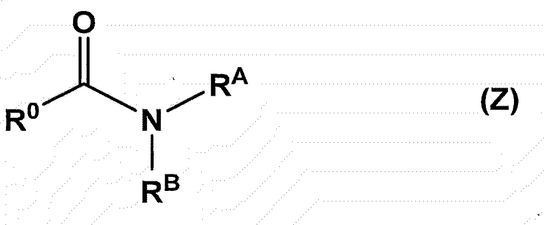
wherein R⁰ represents an ethyl group, a propyl group, or an isopropyl group, and R^{A} and R^{B} each independently represent an alkyl group having 1 to 4 carbon atoms, 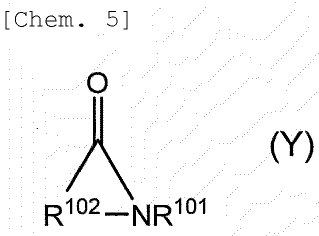
wherein R¹⁰¹ represents a hydrogen atom or an alkyl group having 1 to 6 carbon atoms, and R¹⁰² represents an alkylene group having 1 to 6 carbon atoms or a group represented by formula (Y1) below: 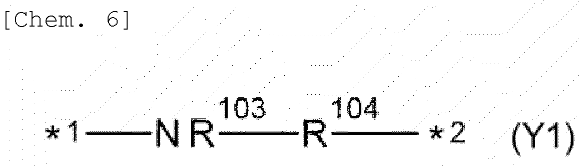
wherein R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in formula (Y), and *2 represents a bond bonded to a nitrogen atom in formula (Y).

2. The method for cleaning a semiconductor substrate according to claim 1, wherein in formula (G), the L¹¹ is a methyl group.

3. The method for cleaning a semiconductor substrate according to claim 2, wherein in formula (G), the L¹² is a butyl group or a pentyl group.

4. The method for cleaning a semiconductor substrate according to any one of claims 1 to 3, wherein the quaternary ammonium salt is a halogen-containing quaternary ammonium salt.

5. The method for cleaning a semiconductor substrate according to any one of claims 1 to 4, wherein the adhesive layer is a film obtained using an adhesive composition containing an adhesive component (S) containing at least one selected from a siloxane-based adhesive, an acrylic resin-based adhesive, an epoxy resin-based adhesive, a polyamide-based adhesive, a polystyrene-based adhesive, a polyimide adhesive, and a phenol resin-based adhesive.

6. The method for cleaning a semiconductor substrate according to claim 5, wherein the adhesive component (S) contains a siloxane-based adhesive.

7. The method for cleaning a semiconductor substrate according to claim **6,** wherein the siloxane-based adhesive contains a polyorganosiloxane component (A') that is cured by a hydrosilylation reaction.

8. The method for cleaning a semiconductor substrate according to any one of claims 1 to **7,** wherein the step of releasing and dissolving an adhesive layer includes a step of eliminating the released adhesive layer.

9. A method for producing a processed semiconductor substrate, the method comprising:
a first step of producing a laminate including a semiconductor substrate, a support substrate, and an adhesive layer formed from an adhesive composition;
a second step of processing the semiconductor substrate of the produced laminate;
a third step of separating the semiconductor substrate and the adhesive layer from the support substrate; and
a fourth step of releasing and dissolving the adhesive layer according to the method of any one of claims 1 to 8 to remove the adhesive layer on the semiconductor substrate.

10. A releasing and dissolving composition for releasing and dissolving an adhesive layer formed on a semiconductor substrate when the semiconductor substrate is cleaned to remove the adhesive layer,
wherein the releasing and dissolving composition corresponds to at least one of (i) to (iii) below:
(i) the releasing and dissolving composition contains
a component [I] below, a component [II] below, and a component [III] below, and
wherein a content of component [I] is 0.1 to 5 mass%, with respect to the releasing and dissolving composition, and
with respect to 100 mass% of aprotic solvents in the releasing and dissolving composition, a content of the component [II] is 5 mass% or more and 20 mass% or less, and a content of the component [III] is 60 mass% or more;
(ii) the releasing and dissolving composition contains
a component [I] below, a component [II] below, a component [III] below, and a component [IV] below,
the component [IV] contains a solvent represented by formula (L) below, and
wherein a content of the component [I] is 0.1 to 5 mass%, with respect to the releasing and dissolving composition, and
with respect to 100 mass% of aprotic solvents in the releasing and dissolving composition, a content of the component [III] is more than 31 mass%, a content of the component [IV] is less than 30 mass%, and a content of the component [II] is 5 mass% or more and 50 mass% or less; and
(iii) the releasing and dissolving composition contains
a component [I] below, a component [II] below, a component [III] below, and a component [IV] below,
the component [IV] contains a solvent represented by formula (T) below, and
wherein a content of the component [I] is 0.1 to 5 mass%, with respect to the releasing and dissolving composition, and
with respect to 100 mass% of aprotic solvents in the releasing and dissolving composition, a content of the component [III] is more than 31 mass%, a content of the component [IV] is less than 30 mass%, and a content of the component [II] is 5 mass% or and 20 mass% or less,
in which the component [I] represents a quaternary ammonium salt,
the component [II] represents an amide-based solvent, which is an acid amide derivative represented by formula (Z) below or a compound represented by formula (Y) below,
the component [III] represents a solvent represented by formula (G) below,
the component [IV] represents a solvent represented by formula (T) below or formula (L) below,
aprotic solvents are solvents having no hydroxyl group (-OH): 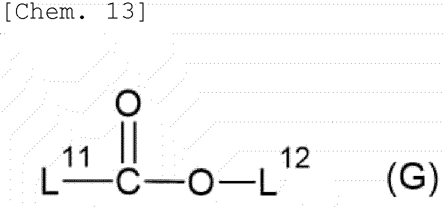
wherein L¹¹ and L¹² each independently represent an alkyl group having 1 to 6 carbon atoms, and a total number of carbon atoms in the alkyl group of L¹¹ and the alkyl group of L¹² is 7 or less, 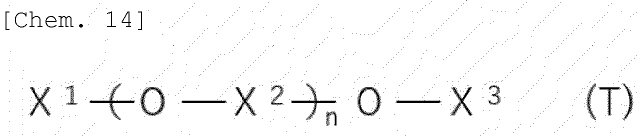
X¹ and X³ each independently represent an alkyl group or an acyl group (X⁴-C(=O) -), X² represents an alkylene group, n represents 2 or 3, and X⁴ represents an alkyl group,
[Chem. 15] **L¹-L³-L² (L)**
wherein L¹ and L² each independently represent an alkyl group having 2 to 5 carbon atoms, and L³ represents O or S, 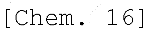 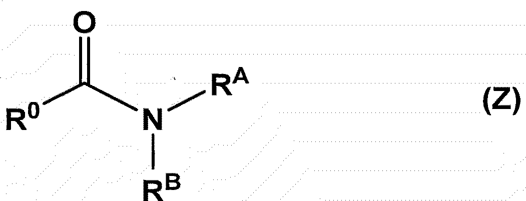
wherein R⁰ represents an ethyl group, a propyl group, or an isopropyl group, and R^{A} and R^{B} each independently represent an alkyl group having 1 to 4 carbon atoms, 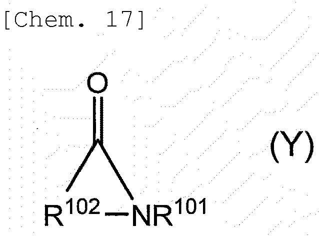
wherein R¹⁰¹ represents a hydrogen atom or an alkyl group having 1 to 6 carbon atoms, and R¹⁰² represents an alkylene group having 1 to 6 carbon atoms or a group represented by formula (Y1) below: 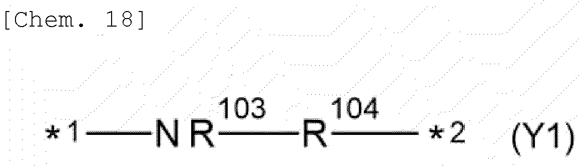
wherein R¹⁰³ represents a hydrogen atom or an alkyl group having 1 to 6 carbon atoms, R¹⁰⁴ represents an alkylene group having 1 to 5 carbon atoms, *1 represents a bond bonded to a carbon atom in formula (Y), and *2 represents a bond bonded to a nitrogen atom in formula (Y).

11. The releasing and dissolving composition according to claim 10, wherein in formula (G), the L¹¹ is a methyl group.

12. The releasing and dissolving composition according to claim 11, wherein in formula (G), the L¹² is a butyl group or a pentyl group.

13. The releasing and dissolving composition according to any one of claims 10 to 12, wherein the quaternary ammonium salt is a halogen-containing quaternary ammonium salt.

## Patentansprüche

1. Verfahren zum Reinigen eines Halbleitersubstrats, wobei das Verfahren einen Schritt des Ablösens und Auflösens einer auf einem Halbleitersubstrat ausgebildeten Klebeschicht unter Verwendung einer Ablöse- und Auflösungszusammensetzung umfasst,
wobei die Ablöse- und Auflösungszusammensetzung mindestens einem von (i) bis (iii) unten entspricht:
(i) die Ablöse- und Auflösungszusammensetzung enthält
eine nachstehende Komponente [I], eine nachstehende Komponente [II] und eine nachstehende Komponente [III], und
wobei ein Gehalt der Komponente [I] 0,1 bis 5 Massen-%, bezogen auf die Ablöse- und Auflösungszusammensetzung, beträgt und
bezogen auf 100 Massen-% aprotischer Lösungsmittel in der Ablöse- und Auflösungszusammensetzung, ein Gehalt der Komponente [II] 5 Massen-% oder mehr und 20 Massen-% oder weniger beträgt und ein Gehalt der Komponente [III] beträgt 60 Massen-% oder mehr beträgt;
(ii) die Ablöse- und Auflösungszusammensetzung enthält
eine nachstehende Komponente [I], eine nachstehende Komponente [II], eine nachstehende Komponente [III] und eine nachstehende Komponente [IV],
wobei die Komponente [IV] ein durch die nachstehende Formel (L) dargestelltes Lösungsmittel enthält, und wobei ein Gehalt der Komponente [I] 0,1 bis 5 Massen-%, bezogen auf die Ablöse- und Auflösungszusammensetzung, beträgt, und
bezogen auf 100 Massen-% aprotischer Lösungsmittel in der Ablöse- und Auflösungszusammensetzung, ein Gehalt der Komponente [III] mehr als 31 Massen-% beträgt, ein Gehalt der Komponente [IV] weniger als 30 Massen-% beträgt und ein Gehalt der Komponente [II] 5 Massen-% oder mehr und 50 Massen-% oder weniger beträgt; und
(iii) die Ablöse- und Auflösungszusammensetzung enthält
eine nachstehende Komponente [I], eine nachstehende Komponente [II], eine nachstehende Komponente [III] und eine nachstehende Komponenten [IV],
wobei die Komponente [IV] ein durch die nachstehende Formel (T) dargestelltes Lösungsmittel enthält, und
wobei ein Gehalt der Komponente [I] 0,1 bis 5 Massen-%, bezogen auf die Ablöse- und Auflösungszusammensetzung, beträgt, und
bezogen auf 100 Massen-% aprotischer Lösungsmittel in der Ablöse- und Auflösungszusammensetzung ein Gehalt der Komponente [III] mehr als 31 Massen-% beträgt, ein Gehalt der Komponente [IV] weniger als 30 Massen-% beträgt und ein Gehalt der Komponente [II] 5 Massen-% oder mehr und 20 Massen-% oder weniger beträgt,
wobei die Komponente [I] ein quaternäres Ammoniumsalz darstellt,
die Komponente [II] ein amidbasiertes Lösungsmittel darstellt, das ein Säureamidderivat, dargestellt durch die nachstehende Formel (Z), oder eine Verbindung, dargestellt durch die nachstehende Formel (Y), ist,
die Komponente [III] ein Lösungsmittel, dargestellt durch die nachstehende Formel (G), darstellt,
die Komponente [IV] ein Lösungsmittel, dargestellt durch die nachstehende Formel (T) oder die nachstehende Formel (L), darstellt, und
aprotische Lösungsmittel Lösungsmittel ohne Hydroxylgruppe (-OH) sind: 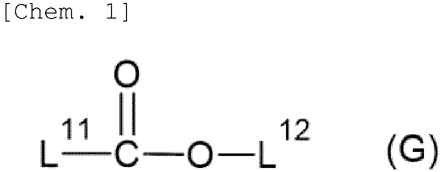
worin L¹¹ und L¹² jeweils unabhängig voneinander eine Alkylgruppe mit 1 bis 6 Kohlenstoffatomen darstellen und eine Gesamtzahl der Kohlenstoffatome in der Alkylgruppe von L¹¹ und der Alkylgruppe von L¹² 7 oder weniger beträgt, 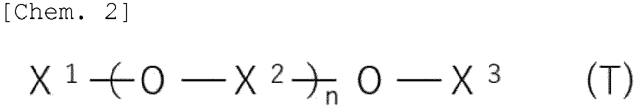
worin X¹ und X³ jeweils unabhängig voneinander eine Alkylgruppe oder eine Acylgruppe (X⁴-C(=O)-) darstellen, X² eine Alkylengruppe darstellt, n 2 oder 3 darstellt und X⁴ eine Alkylgruppe darstellt,
[Chem. 3] **L¹-L³-L² (L)**
worin L¹ und L² jeweils unabhängig voneinander eine Alkylgruppe mit 2 bis 5 Kohlenstoffatomen darstellen und L³ O oder S darstellt, 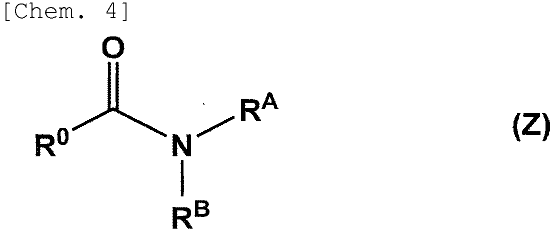
worin R⁰ eine Ethylgruppe, eine Propylgruppe oder eine Isopropylgruppe darstellt und R^{A} und R^{B} jeweils unabhängig voneinander eine Alkylgruppe mit 1 bis 4 Kohlenstoffatomen darstellen, 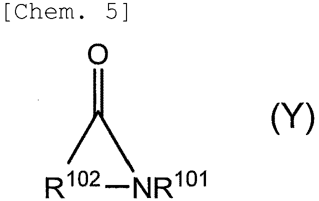
worin R¹⁰¹ ein Wasserstoffatom oder eine Alkylgruppe mit 1 bis 6 Kohlenstoffatomen darstellt und R¹⁰² eine Alkylengruppe mit 1 bis 6 Kohlenstoffatomen oder eine durch die nachstehende Formel (Y1) dargestellte Gruppe darstellt: 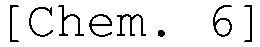 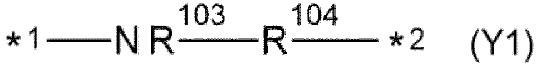
worin R¹⁰³ ein Wasserstoffatom oder eine Alkylgruppe mit 1 bis 6 Kohlenstoffatomen darstellt, R¹⁰⁴ eine Alkylengruppe mit 1 bis 5 Kohlenstoffatomen darstellt, *1 eine an ein Kohlenstoffatom in der Formel (Y) gebundene Bindung darstellt und *2 eine an ein Stickstoffatom in der Formel (Y) gebundene Bindung darstellt.

2. Verfahren zum Reinigen eines Halbleitersubstrats gemäß Anspruch 1, wobei in Formel (G) L¹¹ eine Methylgruppe ist.

3. Verfahren zum Reinigen eines Halbleitersubstrats gemäß Anspruch 2, wobei in Formel (G) L¹² eine Butylgruppe oder eine Pentylgruppe ist.

4. Verfahren zum Reinigen eines Halbleitersubstrats gemäß einem der Ansprüche 1 bis 3, wobei das quaternäre Ammoniumsalz ein halogenhaltiges quaternäres Ammoniumsalz ist.

5. Verfahren zum Reinigen eines Halbleitersubstrats gemäß einem der Ansprüche 1 bis 4, wobei die Klebeschicht ein Film ist, der unter Verwendung einer Klebstoffzusammensetzung erhalten wird, die eine Klebstoffkomponente (S) enthält, die mindestens einen, ausgewählt aus einem Klebstoff auf Siloxanbasis, einem Klebstoff auf Acrylharzbasis, einem Klebstoff auf Epoxidharzbasis, einem Klebstoff auf Polyamidbasis, einem Klebstoff auf Polystyrolbasis, einem Polyimid-Klebstoff und einem Klebstoff auf Phenolharzbasis, umfasst.

6. Verfahren zum Reinigen eines Halbleitersubstrats gemäß Anspruch 5, wobei die Klebstoffkomponente (S) einen Klebstoff auf Siloxanbasis enthält.

7. Verfahren zum Reinigen eines Halbleitersubstrats gemäß Anspruch 6, wobei der Klebstoff auf Siloxanbasis eine Polyorganosiloxan-Komponente (A') enthält, die durch eine Hydrosilylierungsreaktion gehärtet wird.

8. Verfahren zum Reinigen eines Halbleitersubstrats gemäß einem der Ansprüche 1 bis 7, wobei der Schritt des Ablösens und Auflösens einer Klebeschicht einen Schritt des Eliminierens der abgelösten Klebeschicht umfasst.

9. Verfahren zur Herstellung eines bearbeiteten Halbleitersubstrats, wobei das Verfahren umfasst:
einen ersten Schritt des Herstellens eines Laminats, das ein Halbleitersubstrat, ein Trägersubstrat und eine aus einer Klebstoffzusammensetzung gebildete Klebeschicht umfasst;
einen zweiten Schritt des Bearbeitens des Halbleitersubstrats des hergestellten Laminats;
einen dritten Schritt des Trennens des Halbleitersubstrats und der Klebeschicht von dem Trägersubstrat; und
einen vierten Schritt des Ablösens und Auflösens der Klebeschicht gemäß dem Verfahren gemäß einem der Ansprüche 1 bis 8, um die Klebeschicht auf dem Halbleitersubstrat zu entfernen.

10. Ablöse- und Auflösungszusammensetzung zum Ablösen und Auflösen einer auf einem Halbleitersubstrat gebildeten Klebeschicht, wenn das Halbleitersubstrat zum Entfernen der Klebeschicht gereinigt wird,
wobei die Ablöse- und Auflösungszusammensetzung mindestens einem von (i) bis (iii) unten entspricht:
(i) die Ablöse- und Auflösungszusammensetzung enthält
eine nachstehende Komponente [I], eine nachstehende Komponente [II] und eine nachstehende Komponente [III], und
wobei ein Gehalt der Komponente [I] 0,1 bis 5 Massen-%, bezogen auf die Ablöse- und Auflösungszusammensetzung, beträgt und
bezogen auf 100 Massen-% aprotischer Lösungsmittel in der Ablöse- und Auflösungszusammensetzung, ein Gehalt der Komponente [II] 5 Massen-% oder mehr und 20 Massen-% oder weniger beträgt und ein Gehalt der Komponente [III] beträgt 60 Massen-% oder mehr beträgt;
(ii) die Ablöse- und Auflösungszusammensetzung enthält
eine nachstehende Komponente [I], eine nachstehende Komponente [II], eine nachstehende Komponente [III] und eine nachstehende Komponente [IV],
wobei die Komponente [IV] ein durch die nachstehende Formel (L) dargestelltes Lösungsmittel enthält, und
wobei ein Gehalt der Komponente [I] 0,1 bis 5 Massen-%, bezogen auf die Ablöse- und Auflösungszusammensetzung, beträgt, und
bezogen auf 100 Massen-% aprotischer Lösungsmittel in der Ablöse- und Auflösungszusammensetzung, ein Gehalt der Komponente [III] mehr als 31 Massen-% beträgt, ein Gehalt der Komponente [IV] weniger als 30 Massen-% beträgt und ein Gehalt der Komponente [II] 5 Massen-% oder mehr und 50 Massen-% oder weniger beträgt; und
(iii) die Ablöse- und Auflösungszusammensetzung enthält
eine nachstehende Komponente [I], eine nachstehende Komponente [II], eine nachstehende Komponente [III] und eine nachstehende Komponenten [IV],
wobei die Komponente [IV] ein durch die nachstehende Formel (T) dargestelltes Lösungsmittel enthält, und
wobei ein Gehalt der Komponente [I] 0,1 bis 5 Massen-%, bezogen auf die Ablöse- und Auflösungszusammensetzung, beträgt, und
bezogen auf 100 Massen-% aprotischer Lösungsmittel in der Ablöse- und Auflösungszusammensetzung ein Gehalt der Komponente [III] mehr als 31 Massen-% beträgt, ein Gehalt der Komponente [IV] weniger als 30 Massen-% beträgt und ein Gehalt der Komponente [II] 5 Massen-% oder mehr und 20 Massen-% oder weniger beträgt,
wobei die Komponente [I] ein quaternäres Ammoniumsalz darstellt,
die Komponente [II] ein amidbasiertes Lösungsmittel darstellt, das ein Säureamidderivat, dargestellt durch die nachstehende Formel (Z), oder eine Verbindung, dargestellt durch die nachstehende Formel (Y), ist,
die Komponente [III] ein Lösungsmittel, dargestellt durch die nachstehende Formel (G), darstellt,
die Komponente [IV] ein Lösungsmittel, dargestellt durch die nachstehende Formel (T) oder die nachstehende Formel (L), darstellt,
aprotische Lösungsmittel Lösungsmittel ohne Hydroxylgruppe (-OH) sind: 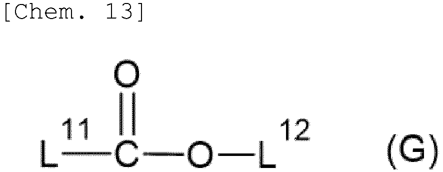
worin L¹¹ und L¹² jeweils unabhängig voneinander eine Alkylgruppe mit 1 bis 6 Kohlenstoffatomen darstellen und eine Gesamtzahl der Kohlenstoffatome in der Alkylgruppe von L¹¹ und der Alkylgruppe von L¹² 7 oder weniger beträgt, 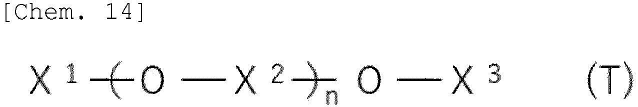
worin X¹ und X³ jeweils unabhängig voneinander eine Alkylgruppe oder eine Acylgruppe (X⁴-C(=O)-) darstellen, X² eine Alkylengruppe darstellt, n 2 oder 3 darstellt und X⁴ eine Alkylgruppe darstellt,
[Chem. 15] **L¹-L³-L² (L)**
worin L¹ und L² jeweils unabhängig voneinander eine Alkylgruppe mit 2 bis 5 Kohlenstoffatomen darstellen und L³ O oder S darstellt, 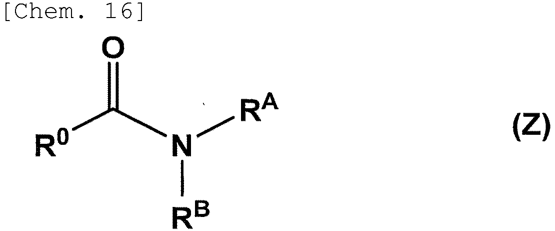
worin R⁰ eine Ethylgruppe, eine Propylgruppe oder eine Isopropylgruppe darstellt und R^{A} und R^{B} jeweils unabhängig voneinander eine Alkylgruppe mit 1 bis 4 Kohlenstoffatomen darstellen, 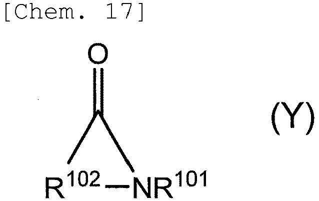
worin R¹⁰¹ ein Wasserstoffatom oder eine Alkylgruppe mit 1 bis 6 Kohlenstoffatomen darstellt und R¹⁰² eine Alkylengruppe mit 1 bis 6 Kohlenstoffatomen oder eine durch die nachstehende Formel (Y1) dargestellte Gruppe darstellt: 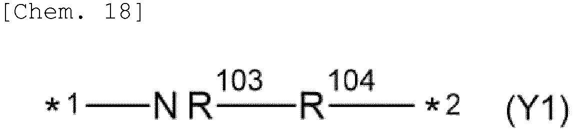
worin R¹⁰³ ein Wasserstoffatom oder eine Alkylgruppe mit 1 bis 6 Kohlenstoffatomen darstellt, R¹⁰⁴ eine Alkylengruppe mit 1 bis 5 Kohlenstoffatomen darstellt,
*1 eine an ein Kohlenstoffatom in der Formel (Y) gebundene Bindung darstellt und *2 eine an ein Stickstoffatom in der Formel (Y) gebundene Bindung darstellt.

11. Ablöse- und Auflösungszusammensetzung gemäß Anspruch 10, wobei in Formel (G) L¹¹ eine Methylgruppe ist.

12. Ablöse- und Auflösungszusammensetzung gemäß Anspruch 11, wobei in Formel (G) L¹² eine Butylgruppe oder eine Pentylgruppe ist.

13. Ablöse- und Auflösungszusammensetzung gemäß einem der Ansprüche 10 bis 12, wobei das quaternäre Ammoniumsalz ein halogenhaltiges quaternäres Ammoniumsalz ist.

## Revendications

1. Procédé de nettoyage d'un substrat semi-conducteur, le procédé comprenant une étape de libération et de dissolution d'une couche adhésive formée sur un substrat semi-conducteur en utilisant une composition de libération et de dissolution,
dans lequel la composition de libération et de dissolution correspond à au moins un de (i) à (iii) ci-dessous :
(i) la composition de libération et de dissolution contient
un composant [I] ci-dessous, un composant [II] ci-dessous, et un composant [III] ci-dessous, et
dans lequel une teneur du composant [I] est de 0,1 % en masse à 5 % en masse, par rapport à la composition de libération et de dissolution, et
par rapport à 100 % en masse de solvants aprotiques dans la composition de libération et de dissolution, une teneur du composant [II] est de 5 % en masse ou plus et de 20 % en masse ou moins, et une teneur du composant [III] est de 60 % en masse ou plus ;
(ii) la composition de libération et de dissolution contient
un composant [I] ci-dessous, un composant [II] ci-dessous, un composant [III] ci-dessous, et un composant [IV] ci-dessous,
le composant [IV] contient un solvant représenté par la Formule (L) ci-dessous, et
dans lequel une teneur du composant [I] est de 0,1 % en masse à 5 % en masse, par rapport à la composition de libération et de dissolution, et
par rapport à 100 % en masse de solvants aprotiques dans la composition de libération et de dissolution, une teneur du composant [III] est de plus de 31 % en masse, une teneur du composant [IV] est de moins de 30 % en masse, et une teneur du composant [II] est de 5 % en masse ou plus et de 50 % en masse ou moins ; et
(iii) la composition de libération et de dissolution contient
un composant [I] ci-dessous, un composant [II] ci-dessous, un composant [III] ci-dessous, et un composant [IV] ci-dessous,
le composant [IV] contient un solvant représenté par la Formule (T) ci-dessous, et
dans lequel une teneur du composant [I] est de 0,1 % en masse à 5 % en masse, par rapport à la composition de libération et de dissolution, et
par rapport à 100 % en masse de solvants aprotiques dans la composition de libération et de dissolution, une teneur du composant [III] est de plus de 31 % en masse, une teneur du composant [IV] est de moins de 30 % en masse, et une teneur du composant [II] est de 5 % en masse ou et de 20 % en masse ou moins,
dans lequel le composant [I] représente un sel d'ammonium quaternaire,
le composant [II] représente un solvant à base d'amide, qui est un dérivé d'amide d'acide représenté par la Formule (Z) ci-dessous ou un composé représenté par la Formule (Y) ci-dessous,
le composant [III] représente un solvant représenté par la Formule (G) ci-dessous,
le composant [IV] représente un solvant représenté par la Formule (T) ci-dessous ou la Formule (L) ci-dessous, et
les solvants aprotiques sont des solvants ne présentant pas de groupe hydroxyle (-OH): 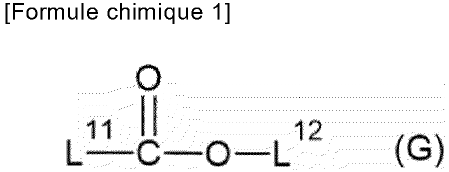
dans lequel L¹¹ et L¹² représentent chacun indépendamment un groupe alkyle présentant 1 à 6 atomes de carbone, et un nombre total d'atomes de carbone dans le groupe alkyle de L¹¹ et le groupe alkyle de L¹² est 7 ou moins, 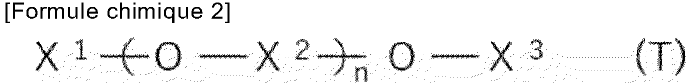
X¹ et X³ représentent chacun indépendamment un groupe alkyle ou un groupe acyle (X⁴-C(=O)-), X² représente un groupe alkylène, n représente 2 ou 3, et X⁴ représente un groupe alkyle,
[Formule chimique 3] **L¹-L³-L² (L)**
dans lequel L¹ et L² représentent chacun indépendamment un groupe alkyle présentant 2 à 5 atomes de carbone, et L³ représente O ou S, 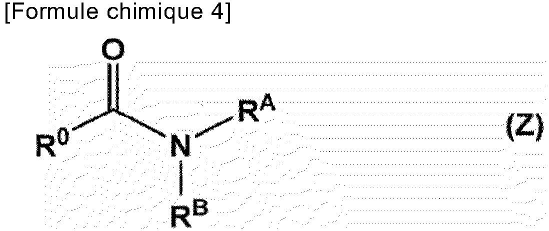
dans lequel R⁰ représente un groupe éthyle, un groupe propyle, ou un groupe isopropyle, et R^{A} et R^{E} représentent chacun indépendamment un groupe alkyle présentant 1 à 4 atomes de carbone, 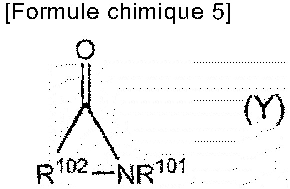
dans lequel R¹⁰¹ représente un atome d'hydrogène ou un groupe alkyle présentant 1 à 6 atomes de carbone, et R¹⁰² représente un groupe alkylène présentant 1 à 6 atomes de carbone ou un groupe représenté par la Formule (Y1) ci-dessous : 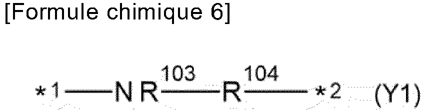
dans lequel R¹⁰³ représente un atome d'hydrogène ou un groupe alkyle présentant 1 à 6 atomes de carbone, R¹⁰⁴ représente un groupe alkylène présentant 1 à 5 atomes de carbone, *1 représente une liaison liée à un atome de carbone dans la Formule (Y), et *2 représente une liaison liée à un atome d'azote dans la Formule (Y).

2. Procédé de nettoyage d'un substrat semi-conducteur selon la revendication 1, dans lequel, dans la Formule (G), le L¹¹ est un groupe méthyle.

3. Procédé de nettoyage d'un substrat semi-conducteur selon la revendication 2, dans lequel, dans la Formule (G), le L¹² est un groupe butyle ou un groupe pentyle.

4. Procédé de nettoyage d'un substrat semi-conducteur selon l'une quelconque des revendications 1 à 3, dans lequel le sel d'ammonium quaternaire est un sel d'ammonium quaternaire contenant un halogène.

5. Procédé de nettoyage d'un substrat semi-conducteur selon l'une quelconque des revendications 1 à 4, dans lequel la couche adhésive est un film obtenu en utilisant une composition adhésive contenant un composant adhésif (S) contenant au moins un adhésif choisi parmi un adhésif à base de siloxane, un adhésif à base de résine acrylique, un adhésif à base de résine époxy, un adhésif à base de polyamide, un adhésif à base de polystyrène, un adhésif polyimide, et un adhésif à base de résine phénolique.

6. Procédé de nettoyage d'un substrat semi-conducteur selon la revendication 5, dans lequel le composant adhésif (S) contient un adhésif à base de siloxane.

7. Procédé de nettoyage d'un substrat semi-conducteur selon la revendication 6, dans lequel l'adhésif à base de siloxane contient un composant polyorganosiloxane (A*'*) qui est durci par une réaction d'hydrosilylation.

8. Procédé de nettoyage d'un substrat semi-conducteur selon l'une quelconque des revendications 1 à 7, dans lequel l'étape de libération et de dissolution d'une couche adhésive inclut une étape d'élimination de la couche adhésive libérée.

9. Procédé de production d'un substrat semi-conducteur traité, le procédé comprenant :
une première étape de production d'un stratifié incluant un substrat semi-conducteur, un substrat support, et une couche adhésive formée à partir d'une composition adhésive ;
une deuxième étape de traitement du substrat semi-conducteur du stratifié produit ;
une troisième étape de séparation du substrat semi-conducteur et de la couche adhésive du substrat support ; et
une quatrième étape de libération et de dissolution de la couche adhésive selon le procédé de l'une quelconque des revendications 1 à 8 pour retirer la couche adhésive sur le substrat semi-conducteur.

10. Composition de libération et de dissolution pour la libération et la dissolution d'une couche adhésive formée sur un substrat semi-conducteur lorsque le substrat semi-conducteur est nettoyé pour retirer la couche adhésive,
dans lequel la composition de libération et de dissolution correspond à au moins un de (i) à (iii) ci-dessous :
(i) la composition de libération et de dissolution contient
un composant [I] ci-dessous, un composant [II] ci-dessous, et un composant [III] ci-dessous, et
dans lequel une teneur du composant [I] est de 0,1 % en masse à 5 % en masse, par rapport à la composition de libération et de dissolution, et
par rapport à 100 % en masse de solvants aprotiques dans la composition de libération et de dissolution, une teneur du composant [II] est de 5 % en masse ou plus et de 20 % en masse ou moins, et une teneur du composant [III] est de 60 % en masse ou plus ;
(ii) la composition de libération et de dissolution contient
un composant [I] ci-dessous, un composant [II] ci-dessous, un composant [III] ci-dessous, et un composant [IV] ci-dessous,
le composant [IV] contient un solvant représenté par la Formule (L) ci-dessous, et
dans lequel une teneur du composant [I] est de 0,1 % en masse à 5 % en masse, par rapport à la composition de libération et de dissolution, et
par rapport à 100 % en masse de solvants aprotiques dans la composition de libération et de dissolution, une teneur du composant [III] est de plus de 31 % en masse, une teneur du composant [IV] est de moins de 30 % en masse, et une teneur du composant [II] est de 5 % en masse ou plus et de 50 % en masse ou moins ; et
(iii) la composition de libération et de dissolution contient
un composant [I] ci-dessous, un composant [II] ci-dessous, un composant [III] ci-dessous, et un composant [IV] ci-dessous,
le composant [IV] contient un solvant représenté par la Formule (T) ci-dessous, et
dans lequel une teneur du composant [I] est de 0,1 % en masse à 5 % en masse, par rapport à la composition de libération et de dissolution, et
par rapport à 100 % en masse de solvants aprotiques dans la composition de libération et de dissolution, une teneur du composant [III] est de plus de 31 % en masse, une teneur du composant [IV] est de moins de 30 % en masse, et une teneur du composant [II] est de 5 % en masse ou et de 20 % en masse ou moins,
dans lequel le composant [I] représente un sel d'ammonium quaternaire,
le composant [II] représente un solvant à base d'amide, qui est un dérivé d'amide d'acide représenté par la Formule (Z) ci-dessous ou un composé représenté par la Formule (Y) ci-dessous,
le composant [III] représente un solvant représenté par la Formule (G) ci-dessous,
le composant [IV] représente un solvant représenté par la Formule (T) ci-dessous ou la Formule (L) ci-dessous,
les solvants aprotiques sont des solvants ne présentant pas de groupe hydroxyle (-OH) : 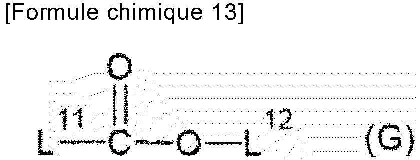
dans lequel L¹¹ et L¹² représentent chacun indépendamment un groupe alkyle présentant 1 à 6 atomes de carbone, et un nombre total d'atomes de carbone dans le groupe alkyle de L¹¹ et le groupe alkyle de L¹² est 7 ou moins, 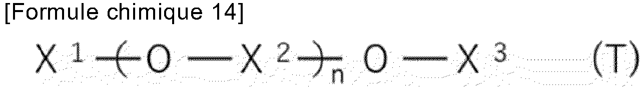
X¹ et X³ représentent chacun indépendamment un groupe alkyle ou un groupe acyle (X⁴-C(=O)-), X² représente un groupe alkylène, n représente 2 ou 3, et X⁴ représente un groupe alkyle,
[Formule chimique 15] **L¹-L³-L² (L)**
dans lequel L¹ et L² représentent chacun indépendamment un groupe alkyle présentant 2 à 5 atomes de carbone, et L³ représente O ou S, 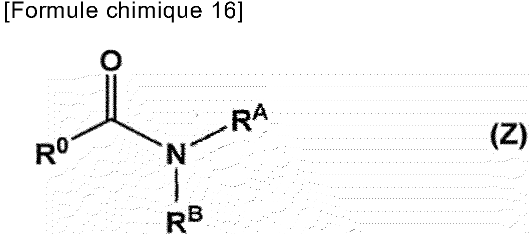
dans lequel R⁰ représente un groupe éthyle, un groupe propyle, ou un groupe isopropyle, et R^{A} et R^{B} représentent chacun indépendamment un groupe alkyle présentant 1 à 4 atomes de carbone, 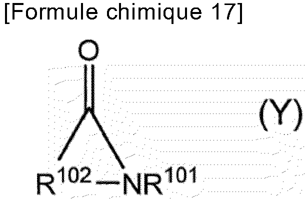
dans lequel R¹⁰¹ représente un atome d'hydrogène ou un groupe alkyle présentant 1 à 6 atomes de carbone, et R¹⁰² représente un groupe alkylène présentant 1 à 6 atomes de carbone ou un groupe représenté par la Formule (Y1) ci-dessous : 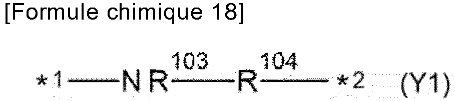
dans lequel R¹⁰³ représente un atome d'hydrogène ou un groupe alkyle présentant 1 à 6 atomes de carbone, R¹⁰⁴ représente un groupe alkylène présentant 1 à 5 atomes de carbone, *1 représente une liaison liée à un atome de carbone dans la Formule (Y), et *2 représente une liaison liée à un atome d'azote dans la Formule (Y).

11. Composition de libération et de dissolution selon la revendication 10, dans lequel, dans la Formule (G), le L¹¹ est un groupe méthyle.

12. Composition de libération et de dissolution selon la revendication 11, dans lequel, dans la Formule (G), le L¹² est un groupe butyle ou un groupe pentyle.

13. Composition de libération et de dissolution selon l'une quelconque des revendications 10 à 12, dans lequel le sel d'ammonium quaternaire est un sel d'ammonium quaternaire contenant un halogène.
